# EUROPEAN PATENT APPLICATION

(11) **EP 4 832 716 A1**
(43) Date of publication of application: **28.10.2026**
(21) Application number: 26167764.5
(22) Date of filing: 25.03.2026
(51) Int. Cl.: H10K 59/122, H10K 59/124, H10K 59/80

(54) **DISPLAY DEVICE, ELECTRONIC DEVICE AND METHOD FOR FABRICATING DISPLAY DEVICE**

(30) Priority: 21.04.2025 KR 20250051471
(71) Applicant: Samsung Display Co., Ltd., Yongin-si, Gyeonggi-do 17113 (KR)
(72) Inventor: YOU, Chun Gi, Yongin-si (KR)
(74) Representative: Marks & Clerk LLP

(57) **Abstract**

The present disclosure relates to a display device with improved image quality, an electronic device that includes the display device, and a method for fabricating the display device. In some aspects, the display device includes a substrate including a sub-pixel area, a reflective electrode disposed in the sub-pixel area, a first electrode disposed on the substrate surrounding the reflective electrode, a pixel defining layer disposed on the first electrode and having an emission area overlapping the first electrode defined, and a separator disposed on the pixel defining layer. The separator includes a first bank disposed on the pixel defining layer so as not to overlap the emission area, and a second bank disposed on the first bank so as not to overlap the emission area. In some aspects, the second bank includes a tip that overlaps the pixel defining layer and does not overlap the first bank.

## Description

### TECHNICAL FIELD

The present disclosure relates to a display device, and more particularly, to a display device with improved image quality, and an electronic device that uses the display device, and a method of fabricating such a display device.

### BACKGROUND

An organic light emitting display apparatus includes display elements whose luminance is changed by a current, such as organic light emitting diodes.

A head mounted display (HMD) to which the organic light emitting display apparatus is applied is an image display device that is worn on a user's head in the form of glasses or a helmet and forms a focus at a distance close to user's eyes in front of the user's eyes. The head mounted display may implement virtual reality (VR) or augmented reality (AR).

The head mounted display magnifies and displays an image displayed by a small display device using a plurality of lenses. Therefore, a display device applied to the head mounted display needs to provide a high-resolution image, for example, an image having a resolution of 3,000 pixels per inch (PPI) or more. To this end, an organic light emitting diode on silicon (OLEDoS), which is a small organic light emitting display device having a high resolution, has been used as the display device applied to the head mounted display. The OLEDoS is a device that displays an image by disposing organic light emitting diodes (OLEDs) on a semiconductor wafer substrate on which complementary metal oxide semiconductors (CMOSs) are disposed.

Accordingly, there is a need for display devices with improved image quality, and for electronic devices with such display devices.

### BRIEF SUMMARY

The disclosure is intended to provide improvements in image quality for display devices. The present disclosure describes a display device capable of providing images with high quality, an electronic device that includes the contemplated display device, and a method for fabricating the display device.

In some embodiments, a display device includes: a substrate including a sub-pixel area; a reflective electrode disposed in the sub-pixel area on the substrate; a first electrode disposed on the substrate so as to surround the reflective electrode; a pixel defining layer which is disposed on the first electrode and in which an emission area overlapping the first electrode is defined; and a separator disposed on the pixel defining layer, wherein the separator includes: a first bank disposed on the pixel defining layer so as not to overlap the emission area; and a second bank disposed on the first bank so as not to overlap the emission area, and the second bank includes a tip that overlaps the pixel defining layer and does not overlap the first bank.

In some embodiments, an etch rate of the first bank may be higher than an etch rate of the second bank.

In some embodiments, the first bank may be made of a material including metal.

In some embodiments, the first bank may be made of a material including any one of titanium nitride, tantalum, and tantalum nitride.

In some embodiments, the second bank may be made of a material including silicon nitride.

In some embodiments, the number of sub-pixel areas may be plural, the pixel defining layer may define a first emission area of a first sub-pixel and a second emission area of a second sub-pixel, and the emission area of the first sub-pixel and the emission area of the second sub-pixel may have different sizes.

In some embodiments, the display device may further comprise an optical auxiliary layer disposed between the reflective electrode and the first electrode.

In some embodiments, the display device may further comprise a barrier electrode disposed between the substrate and the reflective electrode.

In some embodiments, the first electrode may be disposed on side surfaces of the barrier electrode, side surfaces of the reflective electrode, and side surfaces of the optical auxiliary layer, and an upper surface of the optical auxiliary layer.

In some embodiments, the display device may further comprise a planarization layer disposed on side surfaces of the second bank.

In some embodiments, the display device may further comprise a light emitting stack layer disposed on the first electrode, the pixel defining layer, the second bank, and the planarization layer, and a second electrode disposed on the light emitting stack layer.

In some embodiments, at least some of a plurality of light emitting layers included in the light emitting stack layer disposed on the second bank may be disconnected from the light emitting stack layer disposed on the first electrode.

In some embodiments, the pixel defining layer may include: a first pixel defining layer disposed on the first electrode, a second pixel defining layer disposed on the first pixel defining layer, and a third pixel defining layer disposed on the second pixel defining layer.

In some embodiments, an electronic device includes a display device providing a display screen, wherein the display device includes: a substrate including a sub-pixel area; a reflective electrode disposed in the sub-pixel area on the substrate; a first electrode disposed on the substrate so as to surround the reflective electrode; a pixel defining layer which is disposed on the first electrode and in which an emission area overlapping the first electrode is defined; and a separator disposed on the pixel defining layer, the separator includes: a first bank disposed on the pixel defining layer so as not to overlap the emission area; and a second bank disposed on the first bank so as not to overlap the emission area, and the second bank includes a tip that overlaps the pixel defining layer and does not overlap the first bank.

In some embodiments, the display device may include an active area that displays an image and an inactive area that is disposed outside the active area and does not display an image, and a maximum width of the active area is 1.5 inches or less.

In some embodiments, the electronic device may comprise a wearable device including a head mounted display, a smart glasses, or a smart watch.

According to some embodiments, a method is provided for fabricating a display device, the method comprising blocks for: preparing a substrate in which an insulating layer and a via electrode penetrating through the insulating layer are formed; forming a barrier electrode, a reflective electrode, and an optical auxiliary layer that are sequentially stacked on the via electrode; sequentially forming a first preliminary electrode, a first preliminary pixel defining layer, a first preliminary bank, and a second preliminary bank on the optical auxiliary layer and the insulating layer; forming a first electrode, a second preliminary pixel defining layer, a third preliminary bank, and a fourth preliminary bank by patterning the first preliminary electrode, the first preliminary pixel defining layer, the first preliminary bank, and the second preliminary bank; forming a preliminary planarization layer on the first electrode, the second preliminary pixel defining layer, the third preliminary bank, the fourth preliminary bank, and the insulating layer; forming a planarization layer on side surfaces of the fourth preliminary bank by removing the preliminary planarization layer until the fourth preliminary bank is exposed; forming a first photoresist pattern on the fourth preliminary bank and the planarization layer so as not to overlap an emission area of a sub-pixel; and forming a first bank and a second bank by patterning the fourth preliminary bank and the third preliminary bank using the first photoresist pattern as a mask, the second bank being disposed on the first bank, wherein the second bank includes a tip that overlaps the second preliminary pixel defining layer and does not overlap the first bank.

At least some of the above and other features of the invention are set out in the claims.

According to some embodiments, image quality of a display device and an electronic device may be improved.

For example, according to some embodiments, a separator has an undercut structure, and thus, a lateral leakage current may be minimized. As such a lateral leakage current is minimized, a color mixing phenomenon between adjacent sub-pixel areas may be prevented, such that image quality of the display device may be improved.

In addition, according to some embodiments, a first bank included in the separator and made of a metal material surrounds a sub-pixel area, and it is thus possible to block light from the sub-pixel area from traveling to another sub-pixel area adjacent to the sub-pixel area. Accordingly, a color mixing phenomenon between adjacent sub-pixel areas may be prevented, such that image quality of the display device may be improved.

Advantages of the display device of the present disclosure are not limited to the aforementioned, and various other effects are described in the detailed description below.

### BRIEF DESCRIPTION OF THE DRAWINGS

The above and other aspects and features of the present disclosure will become more apparent by describing in detail embodiments thereof with reference to the attached drawings, in which:
FIG. 1 is an exploded perspective view illustrating a display device according to an embodiment of the present disclosure;
FIG. 2 is a block diagram illustrating the display device according to an embodiment of the present disclosure;
FIG. 3 is an equivalent circuit diagram of a first sub-pixel area of the display device according to an embodiment of the present disclosure;
FIG. 4 is a layout diagram illustrating an example of a display panel according to an embodiment of the present disclosure;
FIGs. 5 and 6 are layout diagrams illustrating embodiments of a display area of FIG. 4;
FIG. 7 is a cross-sectional view of an example of the display panel taken along line II-II' of FIG. 5;
FIG. 8 is a cross-sectional view illustrating area A1 of FIG. 7 in detail;
FIG. 9 is a cross-sectional view illustrating area A2 of FIG. 8 in detail;
FIG. 10 is a cross-sectional view of a display device according to another embodiment of the present disclosure; and
FIGs. 11 to 23 are views for describing processes of a method for fabricating the display device according to an embodiment of the present disclosure;
FIG. 24 is a block diagram of an electronic device according to an embodiment of the present disclosure; and
FIGs. 25 to 27 are schematic views of electronic devices according to various embodiments of the present disclosure.

### DETAILED DESCRIPTION OF THE EMBODIMENTS

While specific embodiments are shown in the drawings and described in detail herein below, the present disclosure may be modified in a variety of ways and realized in many different forms. Accordingly, it will be appreciated that the present disclosure is not limited to the specific disclosed forms, and should be construed to include all modifications, equivalents, or replacements included within the scope of the present disclosure.

In addition, spatially relative terms, such as "below", "lower", "above", "upper" and the like, may be used herein for ease of description to describe one element or feature's relationship to another element or feature as shown in the figures.

It will also be understood that when a layer is referred to as being "on" another layer or substrate, it can be directly on the other layer or substrate, or intervening layers may also be present. The same reference numbers indicate the same components throughout the specification. In the attached figures, the thickness of layers and regions is exaggerated for clarity.

Although the terms "first", "second", etc. may be used herein to describe various elements, these elements, should not be limited by these terms. These terms may be used to distinguish one element from another element. Thus, a first element discussed below may be termed a second element without departing from teachings of one or more embodiments of the present disclosure. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

Features of various embodiments of the present disclosure may be combined partially or totally. As will be clearly appreciated by those skilled in the art, technically various interactions and operations are possible. Various embodiments can be practiced individually or in combination.

Hereinafter, specific embodiments will be described with reference to the accompanying drawings. When describing with reference to the drawings, identical or corresponding components are given the same drawing reference numerals and redundant descriptions thereof are omitted.

In the examples below, singular expressions include plural expressions unless the context clearly indicates otherwise.

In the examples below, terms such as "include" or "have" mean that a feature or component described in the specification is present, and do not exclude in advance the possibility that one or more other features or components may be added.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

In the drawings, sizes of components may be exaggerated or reduced for convenience of explanation. For example, a size and thickness of each component shown in the drawing are arbitrarily shown for convenience of explanation, and thus the present implementation of the teachings of the present disclosure are not necessarily limited to what is shown.

Additionally, the terms "about," "generally," and "substantially" are intended to mean, and a person of ordinary skill would understand them to mean, that slight deviations from absolute are included within the scope of the term so modified.

In some embodiments, where the implementation is otherwise feasible, specific process sequences may be performed in a different order than described. For example, two processes described sequentially may be performed substantially simultaneously, or may proceed in the reverse order from that described.

In this specification, "A and/or B" refers to either A, B, or both A and B. And, "at least one of A and B" indicates the case where it is A, or B, or both A and B.

In the following examples, when it is said that a film, region, component, etc. are connected, it includes a case where the films, regions, or components are directly connected, and/or a case where other films, regions, or components are interposed between the films, regions, or components and are indirectly connected. For example, when it is said in this specification that a film, region, component, etc. are electrically connected, it refers to a case where the film, region, component, etc. are directly electrically connected, and/or a case where another film, region, component, etc. is interposed between them and is indirectly electrically connected.

In addition, the terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

A display device according to an embodiment may be included in various electronic devices. In some aspect, an electronic device according to an embodiment includes the display device described above, and may further include a module or device having additional functions in addition to the display device.

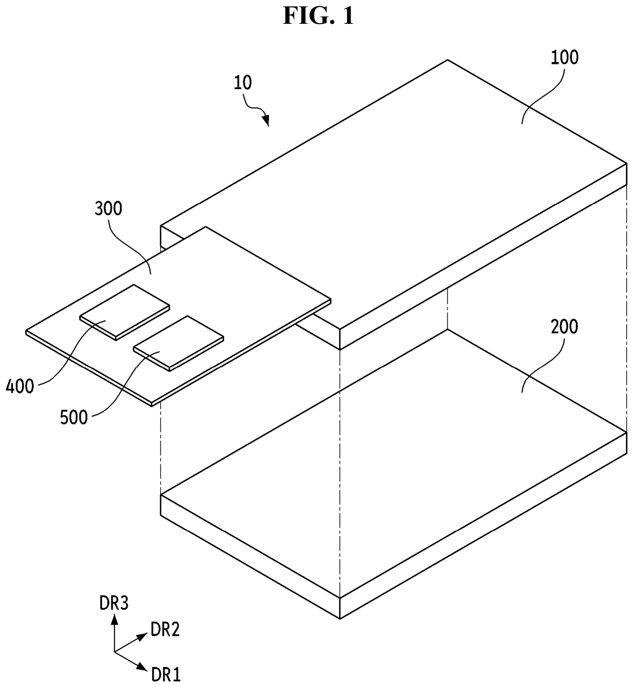

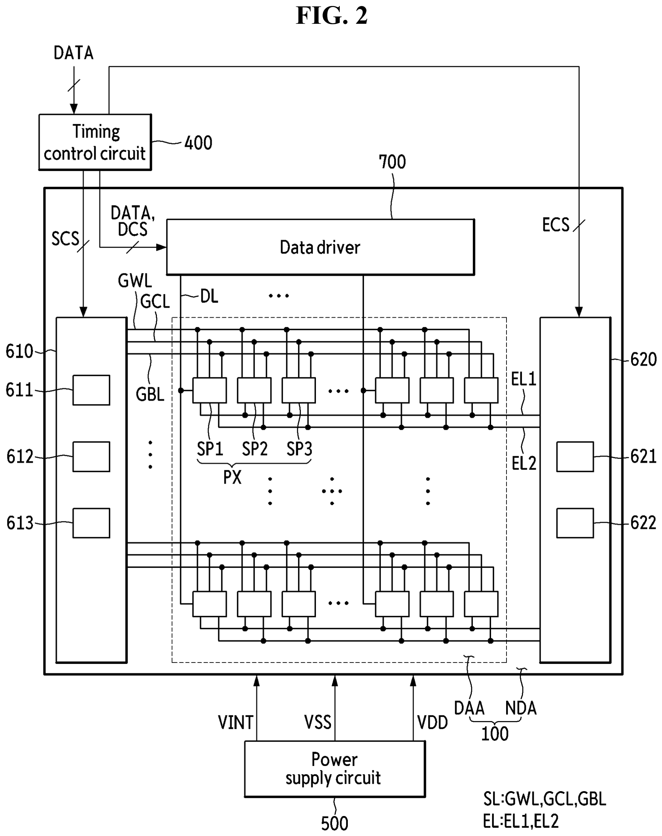

FIG. 1 is an exploded perspective view illustrating a display device 10 according to an embodiment. FIG. 2 is a block diagram illustrating the display device 10 according to an embodiment.

Referring to FIGs. 1 and 2, a display device 10 according to an embodiment is a device that displays a moving image or a still image. The display device 10 according to an embodiment may be implemented in portable electronic devices such as mobile phones, smartphones, tablet personal computers (PCs), mobile communication terminals, electronic notebooks, electronic books, portable multimedia players (PMPs), navigation devices, and ultra mobile PCs (UMPCs). For example, the display device 10 according an embodiment may be a display unit of a television, laptop computer, monitor, billboard, or an Internet of Things (IOTs) device. Alternatively, the display device 10 according an embodiment may be deployed in a smart watch, watch phone, or head mounted display (HMD) for implementing virtual reality and augmented reality.

The display device according to an embodiment may have, for example, a resolution of 4,000 pixels per inch (PPI) or more.

The display device 10 according to an embodiment comprises a display panel 100, a heat dissipation layer 200, a circuit board 300, a timing control circuit 400, and a power supply circuit 500.

The display panel 100 may have a shape similar to a rectangular shape in plan view. For example, the display panel 100 may have a shape similar to a rectangular shape, in plan view, having short sides in a first direction DR1 and long sides in a second direction DR2 crossing the first direction DR1. Thus, the length of the display panel 100 in the direction of DR1 may be shorter than the length of the display panel 100 in the direction of DR2. In the display panel 100, a corner where the short side in the first direction DR1 and the long side in the second direction DR2 meet may be rounded with a selected curvature or may be right-angled. A shape of the display panel 100 in plan view is not limited to the rectangular shape, and may be a shape similar to other polygonal shapes, a circular shape, or an elliptical shape. A shape of the display device 10 in plan view may follow the shape of the display panel 100 in plan view, but an embodiment of the present disclosure is not limited thereto.

The display panel 100 includes a plurality of pixels PX, a plurality of scan lines SL, a plurality of emission control lines EL, a plurality of data lines DL, a scan driver 610, an emission driver 620, and a data driver 700. The display panel 100 may be divided into a display area DAA that displays an image and a non-display area NDA that does not display an image, as illustrated in FIG. 2. The plurality of scan lines SL and the plurality of emission control lines are further described below.

The plurality of pixels PX may be disposed in the display area DAA. The plurality of pixels PX may be arranged in a matrix form in the first direction DR1 and the second direction DR2. The plurality of scan lines SL and the plurality of emission control lines EL may extend in the first direction DR1 and may be disposed in the second direction DR2. The plurality of data lines DL may extend in the second direction DR2 and may be disposed in the first direction DR1.

The plurality of scan lines SL include a plurality of write scan lines GWL, a plurality of control scan lines GCL, and a plurality of bias scan lines GBL. The plurality of emission control lines EL include a plurality of first emission control lines EL1 and a plurality of second emission control lines EL2.

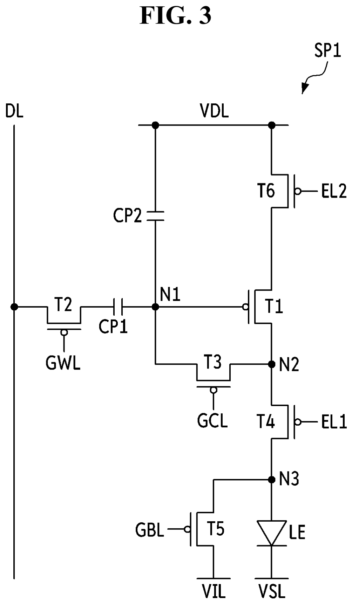

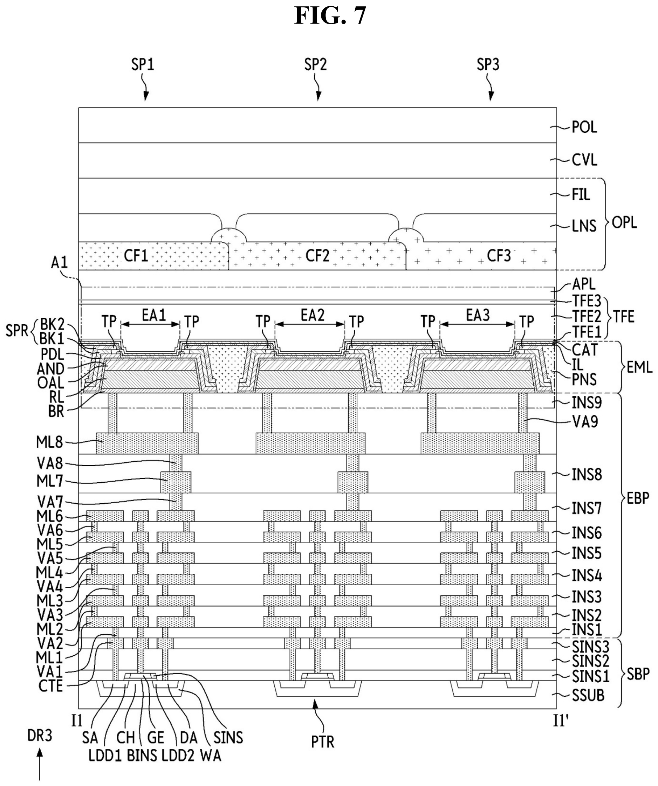

The plurality of pixels PX includes a plurality of sub-pixel areas SP1, SP2, and SP3. The plurality of sub-pixel areas SP1, SP2, and SP3 may include a plurality of pixel transistors as illustrated in FIG. 3, and the plurality of pixel transistors may be formed by a semiconductor process and disposed on a semiconductor substrate SSUB (see FIG. 7). For example, the plurality of pixel transistors may be formed as complementary metal oxide semiconductors (CMOSs), but an embodiment of the present disclosure is not limited thereto.

Each of the plurality of sub-pixel areas SP1, SP2, and SP3 may be connected to any one of the plurality of write scan lines GWL, any one of the plurality of control scan lines GCL, any one of the plurality of bias scan lines GBL, any one of the plurality of first emission control lines EL1, any one of the plurality of second emission control lines EL2, and any one of the plurality of data lines DL. Each of the plurality of sub-pixel areas SP1, SP2, and SP3 may receive a data voltage of the data line DL according to a write scan signal of the write scan line GWL, and allow a light emitting element to emit light according to the data voltage.

One or more of the scan driver 610, the emission driver 620, or the data driver 700 may be disposed in the non-display area NDA.

The scan driver 610 includes a plurality of scan transistors, and the emission driver 620 includes a plurality of emission transistors. The plurality of scan transistors and the plurality of emission transistors may be formed by a semiconductor process and formed on the semiconductor substrate SSUB (see FIG. 7). For example, the plurality of scan transistors and the plurality of emission transistors may be formed as CMOSs, but an embodiment of the present disclosure is not limited thereto.

The scan driver 610 may include a write scan signal output unit 611, a control scan signal output unit 612, and a bias scan signal output unit 613. Each of the write scan signal output unit 611, the control scan signal output unit 612, and the bias scan signal output unit 613 may receive a scan timing control signal SCS from the timing control circuit 400. The write scan signal output unit 611 may generate write scan signals according to the scan timing control signal SCS of the timing control unit 400 and sequentially output the write scan signals to the write scan lines GWL. The control scan signal output unit 612 may generate control scan signals according to the scan timing control signal SCS and sequentially output the control scan signals to the control scan lines GCL. The bias scan signal output unit 613 may generate bias scan signals according to the scan timing control signal SCS and sequentially output the bias scan signals to the bias scan lines GBL.

The emission driver 620 includes a first emission control driver 621 and a second emission control driver 622. Each of the first emission control driver 621 and the second emission control driver 622 may receive an emission timing control signal ECS from the timing control circuit 400. The first emission control driver 621 may generate first emission control signals according to the emission timing control signal ECS and sequentially output the first emission control signals to the first emission control lines EL1. The second emission control driver 622 may generate second emission control signals according to the emission timing control signal ECS and sequentially output the second emission control signals to the second emission control lines EL2.

The data driver 700 may include a plurality of data transistors, and the plurality of data transistors may be formed by a semiconductor process and formed on the semiconductor substrate SSUB (see FIG. 7). For example, the plurality of data transistors may be formed as CMOSs, but an embodiment of the present disclosure is not limited thereto.

The data driver 700 may receive digital video data DATA and a data timing control signal DCS from the timing control circuit 400. The data driver 700 converts the digital video data DATA into analog data voltages according to the data timing control signal DCS and outputs the analog data voltages to the data lines DL. In this case, the sub-pixel areas SP1, SP2, and SP3 may be selected by the write scan signals of the scan driver 610, and the data voltages may be supplied to the selected sub-pixel areas SP1, SP2, and SP3.

The heat dissipation layer 200 (see FIG. 1) may overlap the display panel 100 in a third direction DR3, which is a thickness direction of the display panel 100. The heat dissipation layer 200 may be disposed on one surface, for example, a rear surface, of the display panel 100. The heat dissipation layer 200 serves to dissipate heat generated from the display panel 100. The heat dissipation layer 200 may include a layer made of graphite or metal such as silver (Ag), copper (Cu), or aluminium (Al) having high thermal conductivity.

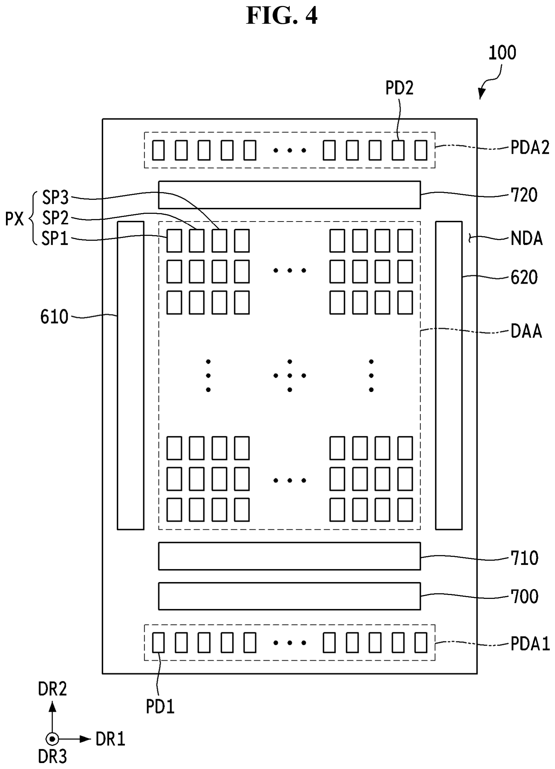

The circuit board 300 (see FIG. 1) may be electrically connected to a plurality of first pads PD1 (see FIG. 4) of a first pad unit PDA1 (see FIG. 4) of the display panel 100 using a conductive adhesive member such as an anisotropic conductive film. The circuit board 300 may be a flexible printed circuit board or a flexible film having a flexible material. Although the circuit board 300 is illustrated in FIG. 1 as an unbent circuit board, in some embodiments, the circuit board 300 may be bent. In this case, one end of the circuit board 300 may be disposed on another surface, such as on the rear surface of the display panel 100 and/or a rear surface of the heat dissipation layer 200. The other end of the circuit board 300 may be connected to the plurality of first pads PD1 (see FIG. 4) of the first pad unit PDA1 (see FIG. 4) of the display panel 100 using the conductive adhesive member. One end of the circuit board 300 may be an end opposite to the other end of the circuit board 300.

The timing control circuit 400 may receive digital video data and timing signals from the outside. The timing control circuit 400 may generate the scan timing control signal SCS, the emission timing control signal ECS, and the data timing control signal DCS for controlling the display panel 100 according to the timing signals. The timing control circuit 400 may output the scan timing control signal SCS to the scan driver 610 and output the emission timing control signal ECS to the emission driver 620. The timing control circuit 400 may output the digital video data and the data timing control signal DCS to the data driver 700.

The power supply circuit 500 (See FIG. 2) may generate a plurality of panel driving voltages according to an external source voltage. For example, the power supply circuit 500 may generate a first driving voltage VSS, a second driving voltage VDD, and a third driving voltage VINT and supply the first driving voltage VSS, the second driving voltage VDD, and the third driving voltage VINT to the display panel 100. The first driving voltage VSS, the second driving voltage VDD, and the third driving voltage VINT will be described later with reference to FIG. 3.

Each of the timing control circuit 400 and the power supply circuit 500 may be formed as an integrated circuit (IC) and attached to one surface of the circuit board 300. In this case, the scan timing control signal SCS, the emission timing control signal ECS, the digital video data DATA, and the data timing control signal DCS of the timing control circuit 400 may be supplied to the display panel 100 through the circuit board 300. In addition, the first driving voltage VSS, the second driving voltage VDD, and the third driving voltage VINT of the power supply circuit 500 may be supplied to the display panel 100 through the circuit board 300.

Alternatively, each of the timing control circuit 400 and the power supply circuit 500 may be disposed in the non-display area NDA of the display panel 100, similar to the scan driver 610, the emission driver 620, and the data driver 700. In this case, the timing control circuit 400 may include a plurality of timing transistors, and the power supply circuit 500 may include a plurality of power transistors. The plurality of timing transistors and the plurality of power transistors may be formed by a semiconductor process and formed on the semiconductor substrate SSUB (see FIG. 7). For example, the plurality of timing transistors and the plurality of power transistors may be formed as CMOSs, but an embodiment of the present disclosure is not limited thereto. Each of the timing control circuit 400 and the power supply circuit 500 may be disposed between the data driver 700 and the first pad unit PDA1 (see FIG. 4).

FIG. 3 is an equivalent circuit diagram of a first sub-pixel area SP1 of the display device 10 according to an embodiment of the disclosure.

Referring to FIG. 3, the first sub-pixel area SP1 may be connected to a write scan line GWL, a control scan line GCL, a bias scan line GBL, a first emission control line EL1, a second emission control line EL2, and a data line DL. In addition, the first sub-pixel area SP1 may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied. That is, the first driving voltage line VSL may be a low potential voltage line, the second driving voltage line VDL may be a high potential voltage line, and the third driving voltage line VIL may be an initialization voltage line. In this case, the first driving voltage VSS may be a voltage lower than the third driving voltage VINT. The second driving voltage VDD may be a voltage higher than the third driving voltage VINT.

The first sub-pixel area SP1 includes a plurality of transistors T1 to T6, a light emitting element LE, a first capacitor CP1, and a second capacitor CP2.

The light emitting element LE emits light according to a driving current flowing through a channel of a first transistor T1. An amount of light emitted from the light emitting element LE may be proportional to the driving current. The light emitting element LE may be disposed between a fourth transistor T4 and the first driving voltage line VSL. A first electrode of the light emitting element LE may be connected to a drain electrode of the fourth transistor T4, and a second electrode of the light emitting element LE may be connected to the first driving voltage line VSL. The first electrode of the light emitting element LE may be an anode electrode, and the second electrode of the light emitting element LE may be a cathode electrode. The light emitting element LE may be an organic light emitting diode including a first electrode, a second electrode, and an organic light emitting layer disposed between the first electrode and the second electrode, but an embodiment of the present disclosure is not limited thereto. For example, the light emitting element LE may be an inorganic light emitting element including a first electrode, a second electrode, and an inorganic semiconductor disposed between the first electrode and the second electrode, and in this case, the light emitting element LE may be a micro light emitting diode.

The first transistor T1 may be a driving transistor controlling a source-drain current Ids (hereinafter referred to as a "driving current") flowing between a source electrode and a drain electrode according to a voltage applied to a gate electrode thereof. The first transistor T1 includes the gate electrode connected to a first node N1, the source electrode connected to a drain electrode of a sixth transistor T6, and the drain electrode connected to a second node N2.

A second transistor T2 may be disposed between one electrode of the first capacitor CP1 and the data line DL. The second transistor T2 is turned on by a write scan signal of the write scan line GWL to connect one electrode of the first capacitor CP1 to the data line DL. For this reason, a data voltage of the data line DL may be applied to one electrode of the first capacitor CP1. The second transistor T2 includes a gate electrode connected to the write scan line GWL, a source electrode connected to the data line DL, and a drain electrode connected to one electrode of the first capacitor CP1.

A third transistor T3 may be disposed between the first node N1 and the second node N2. The third transistor T3 is turned on by a control scan signal of the control scan line GCL to connect the first node N1 to the second node N2. For this reason, when the gate electrode and the drain electrode of the first transistor T1 are connected to each other, the first transistor T1 may operate like a diode. The third transistor T3 includes a gate electrode connected to the control scan line GCL, a source electrode connected to the second node N2, and a drain electrode connected to the first node N1.

The fourth transistor T4 may be connected between the second node N2 and a third node N3. The fourth transistor T4 is turned on by a first emission control signal of the first emission control line EL1 to connect the second node N2 to the third node N3. For this reason, the driving current of the first transistor T1 may be supplied to the light emitting element LE. The fourth transistor T4 includes a gate electrode connected to the first emission control line EL1, a source electrode connected to the second node N2, and the drain electrode connected to the third node N3.

A fifth transistor T5 may be disposed between the third node N3 and the third driving voltage line VIL. The fifth transistor T5 is turned on by a bias scan signal of the bias scan line GBL to connect the third node N3 to the third driving voltage line VIL. For this reason, the third driving voltage VINT of the third driving voltage line VIL may be applied to the first electrode of the light emitting element LE. The fifth transistor T5 includes a gate electrode connected to the bias scan line GBL, a source electrode connected to the third node N3, and a drain electrode connected to the third driving voltage line VIL.

The sixth transistor T6 may be disposed between the source electrode of the first transistor T1 and the second driving voltage line VDL. The sixth transistor T6 is turned on by a second emission control signal of the second emission control line EL2 to connect the source electrode of the first transistor T1 to the second driving voltage line VDL. For this reason, the second driving voltage VDD of the second driving voltage line VDL may be applied to the source electrode of the first transistor T1. The sixth transistor T6 includes a gate electrode connected to the second emission control line EL2, a source electrode connected to the second driving voltage line VDL, and the drain electrode connected to the source electrode of the first transistor T1.

The first capacitor CP1 is formed between the first node N1 and the drain electrode of the second transistor T2. The first capacitor CP1 includes one electrode connected to the drain electrode of the second transistor T2 and the other electrode connected to the first node N1.

The second capacitor CP2 is formed between the gate electrode of the first transistor T1 and the second driving voltage line VDL. The second capacitor CP2 includes one electrode connected to the gate electrode of the first transistor T1 and the other electrode connected to the second driving voltage line VDL.

The first node N1 is a contact point between the gate electrode of the first transistor T1, the drain electrode of the third transistor T3, the other electrode of the first capacitor CP1, and one electrode of the second capacitor CP2. The second node N2 is a contact point between the drain electrode of the first transistor T1, the source electrode of the third transistor T3, and the source electrode of the fourth transistor T4. The third node N3 is a contact point between the drain electrode of the fourth transistor T4, the source electrode of the fifth transistor T5, and the first electrode of the light emitting element LE.

Each of the first to sixth transistors T1 to T6 may be a metal oxide semiconductor field effect transistor (MOSFET). For example, each of the first to sixth transistors T1 to T6 may be a P-type MOSFET, but an embodiment of the present disclosure is not limited thereto. Each of the first to sixth transistors T1 to T6 may be an N-type MOSFET. Alternatively, some of the first to sixth transistors T1 to T6 may be P-type MOSFETs, and the others of the first to sixth transistors T1 to T6 may be N-type MOSFETs.

It has been illustrated in FIG. 3 that the first sub-pixel area SP1 includes six transistors T1 to T6 and two capacitors CP1 and CP2, but it is to be noted that an equivalent circuit diagram of the first sub-pixel area SP1 is not limited to that illustrated in FIG. 3. For example, the numbers of transistors and capacitors of the first sub-pixel area SP1 are not limited to those illustrated in FIG. 3.

In addition, an equivalent circuit diagram of a second sub-pixel area SP2 and an equivalent circuit diagram of a third sub-pixel area SP3 may be substantially the same as the equivalent circuit diagram of the first sub-pixel area SP1 described with reference to FIG. 3. Therefore, a description of the equivalent circuit diagram of the second sub-pixel area SP2 and the equivalent circuit diagram of the third sub-pixel area SP3 is omitted in the present disclosure.

FIG. 4 is a layout diagram illustrating an example of a display panel 100 according to an embodiment of the disclosure.

Referring to FIG. 4, the display area DAA of the display panel 100 according to an embodiment may include a plurality of pixels PX arranged in a matrix form. Each pixel may include a first sub-pixel area SP1, a second sub-pixel area SP2, and a third sub-pixel area SP3. The non-display area NDA of the display panel 100 according to an embodiment includes a scan driver 610, an emission driver 620, a data driver 700, a first distribution circuit 710, a second distribution circuit 720, a first pad unit PDA1, and a second pad unit PDA2.

The scan driver 610 may be disposed on a first side of the display area DAA, and the emission driver 620 may be disposed on a second side of the display area DAA. For example, the scan driver 610 may be disposed on one side of the display area DAA in the first direction DR1, and the emission driver 620 may be disposed on the other side of the display area DAA in the first direction DR1. That is, the scan driver 610 may be disposed on the left side of the display area DAA, and the emission driver 620 may be disposed on the right side of the display area DAA. However, an embodiment of the present disclosure is not limited thereto, and the scan drivers 610 and the emission drivers 620 may be disposed on both the first and second sides of the display area DAA.

The first pad unit PDA1 may include a plurality of first pads PD1 connected to pads or bumps of the circuit board 300 through a conductive adhesive member. The first pad unit PDA1 may be disposed on a third side of the display area DAA. For example, the first pad unit PDA1 may be disposed on one side of the display area DAA in the second direction DR2. The first pad unit PDA1 may be disposed outside the data driver 700 in the second direction DR2. That is, the first pad unit PDA1 may be closer to an edge of the display panel 100 than the data driver 700 is.

The second pad unit PDA2 may include a plurality of second pads PD2 corresponding to inspection pads that inspect whether or not the display panel 100 operates normally. The plurality of second pads PD2 may be connected to a jig or a probe pin or connected to a circuit board for inspection in an inspection process. The circuit board for inspection may be a printed circuit board made of a rigid material or a flexible printed circuit board made of a flexible material.

The second pad unit PDA2 may be disposed on a fourth side of the display area DAA. For example, the second pad unit PDA2 may be disposed on the other side of the display area DAA in the second direction DR2. The second pad unit PDA2 may be disposed outside the second distribution circuit 720 in the second direction DR2. That is, the second pad unit PDA2 may be closer to an edge of the display panel 100 than the second distribution circuit 720 is.

The first distribution circuit 710 distributes data voltages applied through the first pad unit PDA1 to the plurality of data lines DL. For example, the first distribution circuit 710 may distribute data voltages applied through one first pad PD1 of the first pad unit PDA1 to P data lines DL (P is a positive integer of 2 or more), and for this reason, the number of first pads PD1 may be reduced. The first distribution circuit 710 may be disposed on the third side of the display area DAA of the display panel 100. For example, the first distribution circuit 710 may be disposed on one side of the display area DAA in the second direction DR2. That is, the first distribution circuit 710 may be disposed on the lower side of the display area DAA.

The second distribution circuit 720 distributes signals applied through the second pad unit PDA2 to the scan driver 610, the emission driver 620, and the data lines DL. The second pad unit PDA2 and the second distribution circuit 720 may be components for inspecting an operation of each of the pixels PX of the display area DAA. The second distribution circuit 720 may be disposed on the fourth side of the display area DAA of the display panel 100. For example, the second distribution circuit 720 may be disposed on the other side of the display area DAA in the second direction DR2. That is, the second distribution circuit 720 may be disposed on the upper side of the display area DAA.

The display device 10 may include an active area that displays an image and an inactive area that is disposed outside the active area and does not display an image. Here, a maximum width of the active area may be, for example, 1.5 inches or less. Here, the maximum width may refer to the greatest length in a transverse direction measurable in the active area. For example, when the display device 10 has a rectangular shape, the maximum width described above may correspond to a diagonal length of the display device 10.

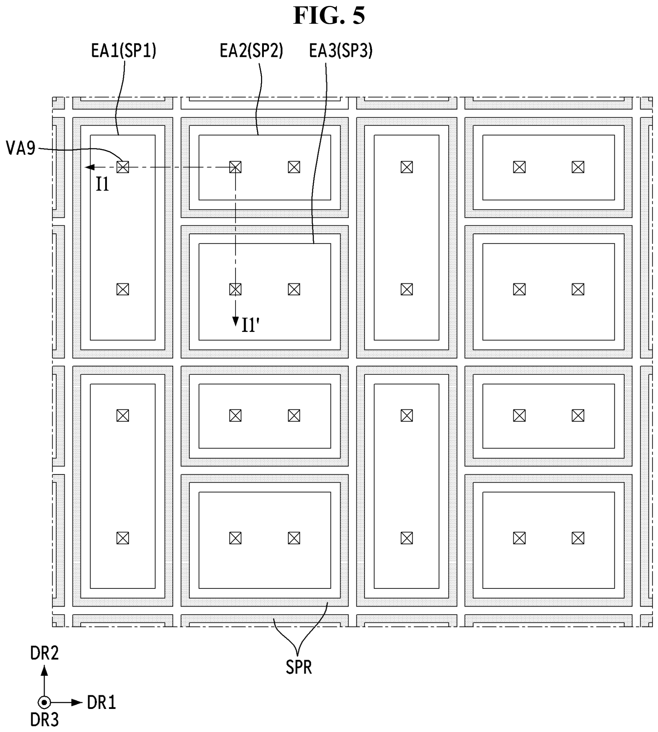

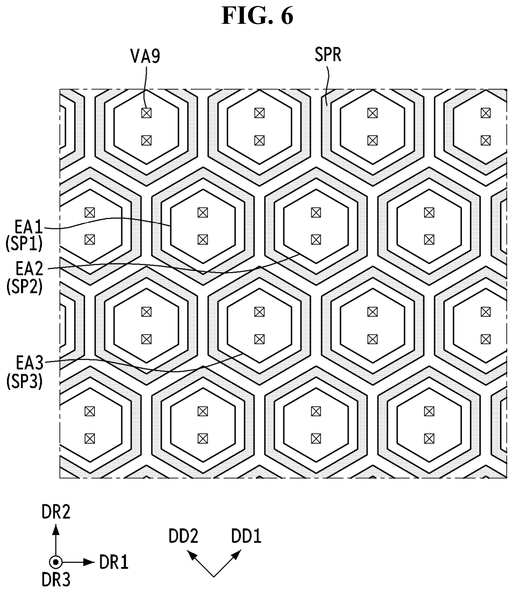

FIGs. 5 and 6 are layout diagrams illustrating embodiments of a display area of FIG. 4.

Referring to FIGs. 5 and 6, each of the plurality of pixels PX includes a first emission area EA1 that is an emission area of the first sub-pixel area SP1, a second emission area EA2 that is an emission area of the second sub-pixel area SP2, and a third emission area EA3 that is an emission area of the third sub-pixel area SP3.

Each of the first emission area EA1, the second emission area EA2, and the third emission area EA3 may have a polygonal shape, a circular shape, an elliptical shape, or an irregular shape in plan view.

A maximum length of the first emission area EA1 in the first direction DR1 may be smaller than a maximum length of the second emission area EA2 in the first direction DR1 and a maximum length of the third emission area EA3 in the first direction DR1. The maximum length of the second emission area EA2 in the first direction DR1 and the maximum length of the third emission area EA3 in the first direction DR1 may be substantially the same as each other.

A maximum length of the first emission area EA1 in the second direction DR2 may be greater than a maximum length of the second emission area EA2 in the second direction DR2 and a maximum length of the third emission area EA3 in the second direction DR2. The maximum length of the second emission area EA2 in the second direction DR2 may be smaller than the maximum length of the third emission area EA3 in the second direction DR2. The maximum length of the first emission area EA1 in the second direction DR2 may be greater than the maximum length of the second emission area EA2 in the second direction DR2.

Each of the first emission area EA1, the second emission area EA2, and the third emission area EA3 may have a rectangular shape including four sides or a hexagonal shape including six straight lines, in plan view, as illustrated in FIGs. 5 and 6, but an embodiment of the present disclosure is not limited thereto. Each of the first emission area EA1, the second emission area EA2, and the third emission area EA3 may have polygonal shapes other than the hexagonal shape, a circular shape, an elliptical shape, or an irregular shape in plan view.

As illustrated in FIG. 5, in each of the plurality of pixels PX, the first emission area EA1 and the second emission area EA2 may be located next to each other in the first direction DR1. In addition, the first emission area EA1 and the third emission area EA3 may neighbor to each other in the first direction DR1. In addition, the second emission area EA2 and the third emission area EA3 may be located next to each other in the second direction DR2. An area of the first emission area EA1, an area of the second emission area EA2, and an area of the third emission area EA3 may be different from each other.

Alternatively, as illustrated in FIG. 6, the first emission area EA1 and the second emission area EA2 may be located next to each other in the first direction DR1, but the second emission area EA2 and the third emission area EA3 may be located next to each other in a first diagonal direction DD1, and the first emission area EA1 and the third emission area EA3 may be located next to each other in a second diagonal direction DD2. The first diagonal direction DD1 may be a direction between the first direction DR1 and the second direction DR2, and may refer to a direction inclined by 45° with respect to the first direction DR1 and the second direction DR2, and the second diagonal direction DD2 may be a direction orthogonal to the first diagonal direction DD1.

The first sub-pixel area SP1 may emit first light that has passed through a first color filter CF1 (see FIG. 7) among light emitted from the first emission area EA1, the second sub-pixel area SP2 may emit second light that has passed through a second color filter CF2 (see FIG. 7) among light emitted from the second emission area EA2, and the third sub-pixel area SP3 may emit third light that has passed through a third color filter CF3 (see FIG. 7) among light emitted from the third emission area EA3.

In some aspects, the first light, the second light, and the third light described above may be light of different wavelength bands. For example, any one of the first light to the third light may be light of a green wavelength band, another of the first light to the third light may be light of a red wavelength band, and the other of the first light to the third light may be light of a blue wavelength band. Here, the light of the blue wavelength band may indicate that a main peak wavelength of the light is included in a wavelength band of approximately 370 nm to 460 nm, the light of the green wavelength band may indicate that a main peak wavelength of the light is included in a wavelength band of approximately 480 nm to 560 nm, and the light of the red wavelength band may indicate that a main peak wavelength of the light is included in a wavelength band of approximately 600 nm to 750 nm.

It has been illustrated in FIGs. 5 and 6 that each of the plurality of pixels PX includes three emission areas EA1, EA2, and EA3, but an embodiment of the present disclosure is not limited thereto.

In addition, an arrangement of the emission areas of the plurality of pixels PX is not limited to those illustrated in FIGs. 5 and 6. For example, the emission areas of the plurality of pixels PX may be disposed in a stripe structure in which the emission areas are arranged in the first direction DR1 or a PenTile^{®} structure in which the emission areas have a diamond arrangement.

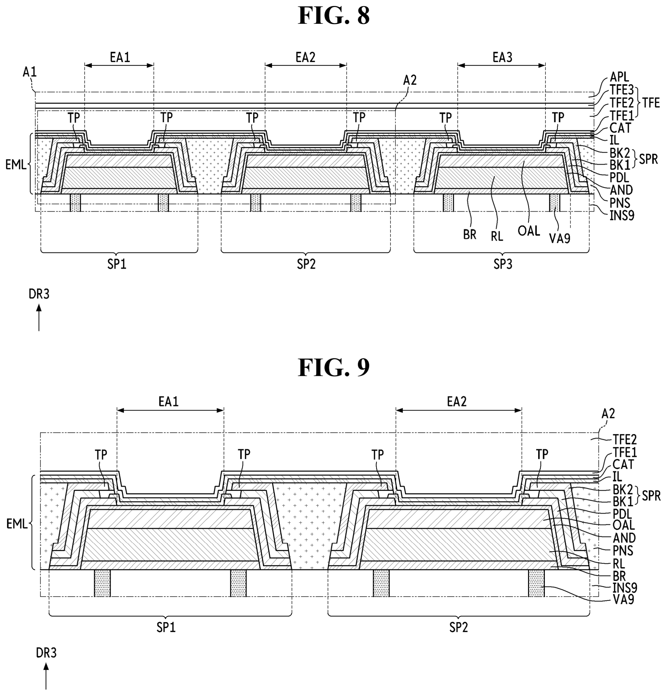

FIG. 7 is a cross-sectional view of an example of the display panel taken along line I1-I1' of FIG. 5. FIG. 8 is a cross-sectional view illustrating area A1 of FIG. 7 in more detail, and FIG. 9 is a cross-sectional view illustrating area A2 of FIG. 8 in more detail.

Referring to FIGs. 7 to 9, the display panel 100 includes a semiconductor backplane SBP, a light emitting element backplane EBP, a display element layer EML, an encapsulation layer TFE, an optical layer OPL, a cover layer CVL, and a polarizing plate POL.

The semiconductor backplane SBP includes a semiconductor substrate SSUB including a plurality of pixel transistors PTR, a plurality of semiconductor insulating layers covering the plurality of pixel transistors PTR, and a plurality of contact terminals CTE electrically connected respectively to the plurality of pixel transistors PTR. The plurality of pixel transistors PTR may be the first to sixth transistors T1 to T6 described with reference to FIG. 3.

The semiconductor substrate SSUB may be a silicon substrate, a germanium substrate, or a silicon-germanium substrate. The semiconductor substrate SSUB may be a substrate doped with first-type impurities. A plurality of well regions WA (described below) may be disposed in an upper surface of the semiconductor substrate SSUB. The plurality of well regions WA may be regions doped with second-type impurities. The second-type impurities may be different from the first-type impurities described above. For example, when the first-type impurities are p-type impurities, the second-type impurities may be n-type impurities. Alternatively, when the first-type impurities are n-type impurities, the second-type impurities may be p-type impurities.

Each of the plurality of well regions WA includes a source region SA corresponding to a source electrode of the pixel transistor PTR, a drain region DA corresponding to a drain electrode of the pixel transistor PTR, and a channel region CH disposed between the source region SA and the drain region DA. (See FIG. 7).

A bottom insulating layer BINS may be disposed between a gate electrode GE and the well region WA. Side surface insulating layers SINS may be disposed on side surfaces of the gate electrode GE. The side surface insulating layers SINS may be disposed on the bottom insulating layer BINS.

Each of the source region SA and the drain region DA may be a region doped with the first-type impurities. The gate electrode GE of the pixel transistor PTR may overlap the well region WA in the third direction DR3, which is a thickness direction of the semiconductor substrate SSUB. The channel region CH may overlap the gate electrode GE in the third direction DR3. The source region SA may be disposed on one side of the gate electrode GE, and the drain region DA may be disposed on the other side of the gate electrode GE.

Each of the plurality of well regions WA further includes a first low-concentration impurity region LDD1 disposed between the channel region CH and the source region SA and a second low-concentration impurity region LDD2 disposed between the channel region CH and the drain region DA. The first low-concentration impurity region LDD1 may be a region having a lower impurity concentration than the source region SA due to the bottom insulating layer BINS. The second low-concentration impurity region LDD2 may be a region having a lower impurity concentration than the drain region DA due to the bottom insulating layer BINS. A distance between the source region SA and the drain region DA may increase by the first low-concentration impurity region LDD1 and the second low-concentration impurity region LDD2. Therefore, a length of the channel region CH of each of the pixel transistors PTR may increase, and thus, punch-through and hot carrier phenomena caused by a short channel may be prevented.

A first semiconductor insulating layer SINS1 may be disposed on the semiconductor substrate SSUB. The first semiconductor insulating layer SINS1 may be formed as a silicon carbonitride (SiCN) or silicon oxide (SiOₓ)-based inorganic film, but an embodiment of the present disclosure is not limited thereto.

A second semiconductor insulating layer SINS2 may be disposed on the first semiconductor insulating layer SINS1. The second semiconductor insulating layer SINS2 may be formed as a silicon oxide (SiOₓ)-based inorganic film, but an embodiment of the present disclosure is not limited thereto.

The plurality of contact terminals CTE may be disposed on the second semiconductor insulating layer SINS2. Each of the plurality of contact terminals CTE may be connected to any one of the gate electrode GE, the source region SA, and the drain region DA of each of the pixel transistors PTR through a hole penetrating through the first semiconductor insulating layer SINS1 and the second semiconductor insulating layer SINS2. Each of the plurality of contact terminals CTE may be made of any one of copper (Cu), aluminium (Al), tungsten (W), molybdenum (Mo), chromium (Cr), gold (Au), titanium (Ti), nickel (Ni), and neodymium (Nd), or alloys thereof.

A third semiconductor insulating layer SINS3 may be disposed on side surfaces of each of the plurality of contact terminals CTE. An upper surface of each of the plurality of contact terminals CTE may be exposed without being covered by the third semiconductor insulating layer SINS3. The third semiconductor insulating layer SINS3 may be formed as a silicon oxide (SiOₓ)-based inorganic film, but an embodiment of the present disclosure is not limited thereto.

The semiconductor substrate SSUB may be replaced with a glass substrate or a polymer resin substrate such as a polyimide substrate. In this case, thin film transistors may be disposed on the glass substrate or the polymer resin substrate. The glass substrate may be a rigid substrate that is not bent, and the polymer resin substrate may be a flexible substrate that may be bent or curved.

The light emitting element backplane EBP includes a plurality of conductive layers ML1 to ML8, a plurality of via electrodes VA1 to VA9, and a plurality of insulating layers INS1 to INS9. In addition, the light emitting element backplane EBP includes a plurality of insulating layers INS1 to INS9 disposed between first to eighth conductive layers ML1 to ML8.

The first to eighth conductive layers ML1 to ML8 serve to implement a circuit of the first sub-pixel area SP1 illustrated in FIG. 3 by connecting the plurality of contact terminals CTE exposed from the semiconductor backplane SBP to each other. For example, only the first to sixth transistors T1 to T6 are formed in the semiconductor backplane SBP, and the connection between the first to sixth transistors T1 to T6 and the formation of the first capacitor CP1 and the second capacitor CP2 are performed through the first to eighth conductive layers ML1 to ML8. In addition, the connection between a drain region corresponding to the drain electrode of the fourth transistor T4, a source region corresponding to the source electrode of the fifth transistor T5, and a first electrode AND of the light emitting element LE is also performed through the first to eighth conductive layers ML1 to ML8.

A first insulating layer INS1 may be disposed on the semiconductor backplane SBP. Each of first via electrodes VA1 may penetrate through the first insulating layer INS1 to be connected to the contact terminal CTE exposed from the semiconductor backplane SBP. Each of the first conductive layers ML1 may be disposed on the first insulating layer INS1 and connected to the first via electrode VA1.

A second insulating layer INS2 may be disposed on the first insulating layer INS1 and the first conductive layers ML1. Each of second via electrodes VA2 may penetrate through the second insulating layer INS2 to be connected to the exposed first conductive layer ML1. Each of the second conductive layers ML2 may be disposed on the second insulating layer INS2 and connected to the second via electrode VA2.

A third insulating layer INS3 may be disposed on the second insulating layer INS2 and the second conductive layers ML2. Each of third via electrodes VA3 may penetrate through the third insulating layer INS3 to be connected to the exposed second conductive layer ML2. Each of the third conductive layers ML3 may be disposed on the third insulating layer INS3 and connected to the third via electrode VA3.

A fourth insulating layer INS4 may be disposed on the third insulating layer INS3 and the third conductive layers ML3. Each of fourth via electrodes VA4 may penetrate through the fourth insulating layer INS4 to be connected to the exposed third conductive layer ML3. Each of the fourth conductive layers ML4 may be disposed on the fourth insulating layer INS4 and connected to the fourth via electrode VA4.

A fifth insulating layer INS5 may be disposed on the fourth insulating layer INS4 and the fourth conductive layers ML4. Each of fifth via electrodes VA5 may penetrate through the fifth insulating layer INS5 to be connected to the exposed fourth conductive layer ML4. Each of the fifth conductive layers ML5 may be disposed on the fifth insulating layer INS5 and connected to the fifth via electrode VA5.

A sixth insulating layer INS6 may be disposed on the fifth insulating layer INS5 and the fifth conductive layers ML5. Each of sixth via electrodes VA6 may penetrate through the sixth insulating layer INS6 to be connected to the exposed fifth conductive layer ML5. Each of the sixth conductive layers ML6 may be disposed on the sixth insulating layer INS6 and connected to the sixth via electrode VA6.

A seventh insulating layer INS7 may be disposed on the sixth insulating layer INS6 and the sixth conductive layers ML6. Each of seventh via electrodes VA7 may penetrate through the seventh insulating layer INS7 to be connected to the exposed sixth conductive layer ML6. Each of the seventh conductive layers ML7 may be disposed on the seventh insulating layer INS7 and connected to the seventh via electrode VA7.

An eighth insulating layer INS8 may be disposed on the seventh insulating layer INS7 and the seventh conductive layers ML7. Each of eighth via electrodes VA8 may penetrate through the eighth insulating layer INS8 to be connected to the exposed seventh conductive layer ML7. Each of the eight conductive layers ML8 may be disposed on the eighth insulating layer INS8 and connected to the eighth via electrode VA8.

The first to eighth conductive layers ML1 to ML8 and the first to eighth via electrodes VA1 to VA8 may be made of substantially the same material. Each of the first to eighth conductive layers ML1 to ML8 and the first to eighth via electrodes VA1 to VA8 may be made of any one of copper (Cu), aluminium (Al), tungsten (W), molybdenum (Mo), chromium (Cr), gold (Au), titanium (Ti), nickel (Ni), and neodymium (Nd), or alloys thereof. The first to eighth via electrodes VA1 to VA8 may be made of substantially the same material. The first to eighth insulating layers INS1 to INS8 may be formed as silicon oxide (SiOₓ)-based inorganic films, but an embodiment of the present disclosure is not limited thereto.

Each of a thickness of the first conductive layer ML1, a thickness of the second conductive layer ML2, a thickness of the third conductive layer ML3, a thickness of the fourth conductive layer ML4, a thickness of the fifth conductive layer ML5, and a thickness of the sixth conductive layer ML6 may be greater than each of a thickness of the first via electrode VA1, a thickness of the second via electrode VA2, a thickness of the third via electrode VA3, a thickness of the fourth via electrode VA4, a thickness of the fifth via electrode VA5, and a thickness of the sixth via electrode VA6. Each of the thickness of the second conductive layer ML2, the thickness of the third conductive layer ML3, the thickness of the fourth conductive layer ML4, the thickness of the fifth conductive layer ML5, and the thickness of the sixth conductive layer ML6 may be greater than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be substantially the same as each other. For example, the thickness of the first conductive layer ML1 may be approximately 1,360 Å, each of the thickness of the second conductive layer ML2, the thickness of the third conductive layer ML3, the thickness of the fourth conductive layer ML4, the thickness of the fifth conductive layer ML5, and the thickness of the sixth conductive layer ML6 may be approximately 1,440 Å, and each of the thickness of the first via electrode VA1, the thickness of the second via electrode VA2, the thickness of the third via electrode VA3, the thickness of the fourth via electrode VA4, the thickness of the fifth via electrode VA5, and the thickness of the sixth via electrode VA6 may be approximately 1,150 Å.

Each of a thickness of the seventh conductive layer ML7 and a thickness of the eighth conductive layer ML8 may be greater than each of the thickness of the first conductive layer ML1, the thickness of the second conductive layer ML2, the thickness of the third conductive layer ML3, the thickness of the fourth conductive layer ML4, the thickness of the fifth conductive layer ML5, and the thickness of the sixth conductive layer ML6. Each of the thickness of the seventh conductive layer ML7 and the thickness of the eighth conductive layer ML8 may be greater than each of a thickness of the seventh via electrode VA7 and a thickness of the eighth via electrode VA8. Each of the thickness of the seventh via electrode VA7 and the thickness of the eighth via electrode VA8 may be greater than each of the thickness of the first via electrode VA1, the thickness of the second via electrode VA2, the thickness of the third via electrode VA3, the thickness of the fourth via electrode VA4, the thickness of the fifth via electrode VA5, and the thickness of the sixth via electrode VA6. The thickness of the seventh conductive layer ML7 and the thickness of the eighth conductive layer ML8 may be substantially the same as each other. For example, each of the thickness of the seventh conductive layer ML7 and the thickness of the eighth conductive layer ML8 may be approximately 9,000 Å. Each of the thickness of the seventh via electrode VA7 and the thickness of the eighth via electrode VA8 may be approximately 6,000 Å.

A ninth insulating layer INS9 may be disposed on the eighth insulating layer INS8 and the eighth conductive layer ML8. The ninth insulating layer INS9 may be formed as a silicon oxide (SiOₓ)-based inorganic film, but an embodiment of the present disclosure is not limited thereto.

Each of ninth via electrodes VA9 may penetrate through the ninth insulating layer INS9 to be connected to the exposed eighth conductive layer ML8. Each of the ninth via electrodes VA9 may be made of any one of copper (Cu), aluminium (Al), tungsten (W), molybdenum (Mo), chromium (Cr), gold (Au), titanium (Ti), nickel (Ni), and neodymium (Nd), or alloys thereof. A thickness of the ninth via electrode VA9 may be approximately 16,500 Å.

The display element layer EML may be disposed on the light emitting element backplane EBP. The display element layer EML may include a plurality of barrier electrodes BR, a plurality of reflective electrodes RL, a planarization layer PNS, a plurality of pixel defining layers PDL, a plurality of first electrodes AND, a light emitting stack layer IL, and a second electrode CAT, and a separator SPR.

In addition, the display element layer EML may include a first emission area EA1, a second emission area EA2, and a third emission area EA3. Each of the first emission area EA1, the second emission area EA2, and the third emission area EA3 may be an area where the first electrode AND, the light emitting stack layer IL, and the second electrode CAT are sequentially stacked. Each of the first emission area EA1, the second emission area EA2, and the third emission area EA3 may be an area where the light emitting element LE including the first electrode AND, the light emitting stack layer IL, and the second electrode CAT is disposed. Each of the first emission area EA1, the second emission area EA2, and the third emission area EA3 may be partitioned by the pixel defining layer PDL.

The plurality of barrier electrodes BR may be disposed on the ninth insulating layer INS9. For example, the plurality of barrier electrodes BR may be disposed on the ninth insulating layer INS9 so as to be connected to a plurality of ninth via electrodes VA9, respectively. The barrier electrode BR may prevent a material (e.g., tungsten) included in the ninth reflective electrode RL from being diffused. Each of the plurality of barrier electrodes BR may be made of titanium nitride (TiN) or transparent conductive oxide. For example, the transparent conductive oxide may be indium tin oxide (ITO) or indium zinc oxide (IZO), but an embodiment of the present disclosure is not limited thereto.

The plurality of reflective electrodes RL may be disposed on the plurality of barrier electrodes BR, respectively. Each of the reflective electrodes RL may be made of any one of copper (Cu), aluminium (Al), tungsten (W), molybdenum (Mo), chromium (Cr), gold (Au), titanium (Ti), nickel (Ni), and neodymium (Nd), or alloys thereof. For example, each of the reflective electrodes RL may include aluminium (Al) having high reflectivity.

Optical auxiliary layers OAL may be disposed on the plurality of reflective electrodes RL, respectively. The optical auxiliary layer OAL may be formed as a silicon oxide (SiOₓ)-based inorganic film, but an embodiment of the present disclosure is not limited thereto.

The optical auxiliary layer OAL may be disposed between the reflective electrode RL and the first electrode AND. (See FIG. 7). In some embodiments, a barrier electrode BR may be disposed between the insulating layer INS9 and the reflective electrode RL.

Each of the light emitting elements LE may include the first electrode AND, the light emitting stack layer IL, and the second electrode CAT.

The first electrode AND of each of the light emitting elements LE may be disposed on side surfaces of the barrier electrode BR, side surfaces of the reflective electrode RL, an upper surface of the optical auxiliary layer OAL, and side surfaces of the optical auxiliary layer OAL. The first electrode AND of each of the light emitting elements LE may be in contact with and electrically connected to the side surfaces of the reflective electrode RL and the side surfaces of the barrier electrode BR.

A thickness of the first electrode AND on the side surfaces of the optical auxiliary layer OAL, the side surfaces of the reflective electrode RL, and the side surfaces of the barrier electrode BR may be different from a thickness of the first electrode AND on the upper surface of the optical auxiliary layer OAL. For example, the thickness of the first electrode AND on the side surfaces of the optical auxiliary layer OAL, the side surfaces of the reflective electrode RL, and the side surfaces of the barrier electrode BR may be smaller than the thickness of the first electrode AND on the upper surface of the optical auxiliary layer OAL.

The first electrode AND of each of the light emitting elements LE may be connected to the drain region DA or the source region SA of the pixel transistor PTR through the barrier electrode BR, the first to ninth via electrodes VA1 to VA9, the first to eighth conductive layers ML1 to ML8, and the contact terminal CTE.

The first electrodes AND of the sub-pixel areas SP1, SP2, and SP3 may be disconnected from each other so as not to be connected to each other. For example, the first electrode AND disposed in the first sub-pixel area SP1 may be disconnected from the first electrode AND disposed in the second sub-pixel area SP2, and the first electrode AND disposed in the second sub-pixel area SP2 may be disconnected from the first electrode AND disposed in the third sub-pixel area SP3. In other words, when a structure including the plurality of first electrodes AND disposed in the plurality of sub-pixel areas SP1, SP2, and SP3 is defined as a first electrode structure, the first electrode structure may be disconnected between adjacent sub-pixel areas SP1, SP2, and SP3. The first electrode AND of each of the light emitting elements LE may include a transparent conductive material. For example, the first electrode AND may be made of a material including ITO. Alternatively, the first electrode AND may be made of any one of copper (Cu), aluminium (Al), tungsten (W), molybdenum (Mo), chromium (Cr), gold (Au), titanium (Ti), nickel (Ni), and neodymium (Nd), or alloys thereof. For example, the first electrode AND of each of the light emitting elements LE may be made of titanium nitride (TiN).

The pixel defining layer PDL may partition the first emission areas EA1, the second emission areas EA2, and the third emission areas EA3. The pixel defining layer PDL may be disposed on a partial area of the first electrode AND of each of the light emitting elements LE. The pixel defining layer PDL may cover an edge of the first electrode AND of each of the light emitting elements LE. For example, the pixel defining layer PDL may have a plurality of openings respectively defining a plurality of emission areas EA1, EA2, and EA3. An opening defining the first emission area EA1 may penetrate through the pixel defining layer PDL so as to overlap the first electrode AND of the first emission area EA1, an opening defining the second emission area EA2 may penetrate through the pixel defining layer PDL so as to overlap the first electrode AND of the second emission area EA2, and an opening defining the third emission area EA3 may penetrate through the pixel defining layer PDL so as to overlap the first electrode AND of the third emission area EA3. The pixel defining layer PDL may be made of a material including silicon oxide (SiO₂).

The first emission area EA1, the second emission area EA2, and the third emission area EA3 may have different sizes. For example, in plan view, a size of the second emission area EA2 may be greater than a size of the first emission area EA1 and smaller than a size of the third emission area EA3. In this case, the plurality of emission areas EA1, EA2, and EA3 adjacent to each other may overlap color filters transmitting light of different colors, respectively. For example, the first emission area EA1 may overlap a first color filter CF1, the second emission area EA2 may overlap a second color filter CF2, and the third emission area EA3 may overlap a third color filter CF3. However, types of the respective color filters CF1, CF2, and CF3 (e.g., colors of the color filters) overlapping the respective emission areas EA1, EA2, and EA3 are not limited thereto.

The pixel defining layers PDL of the sub-pixel areas SP1, SP2, and SP3 may be disconnected from each other so as not to be connected to each other. For example, the pixel defining layer PDL disposed in the first sub-pixel area SP1 may be disconnected from the pixel defining layer PDL disposed in the second sub-pixel area SP2, and the pixel defining layer PDL disposed in the second sub-pixel area SP2 may be disconnected from the pixel defining layer PDL disposed in the third sub-pixel area SP3. In other words, when a structure including the plurality of pixel defining layers PDL disposed in the plurality of sub-pixel areas SP1, SP2, and SP3 is defined as a pixel defining structure, the pixel defining structure may be disconnected between the adjacent sub-pixel areas SP1, SP2, and SP3.

The first emission area EA1 may be defined as an area where the first electrode AND, the light emitting stack layer IL, and the second electrode CAT are sequentially stacked in the first sub-pixel area SP1 to emit light. The second emission area EA2 may be defined as an area where the first electrode AND, the light emitting stack layer IL, and the second electrode CAT are sequentially stacked in the second sub-pixel area SP2 to emit light. The third emission area EA3 may be defined as an area where the first electrode AND, the light emitting stack layer IL, and the second electrode CAT are sequentially stacked in the third sub-pixel area SP3 to emit light.

The separators SPR may be disposed on the pixel defining layers PDL, respectively. In plan view, as illustrated in FIGs. 7 to 9, a plurality of separators SPR may surround the plurality of emission areas EA1, EA2, and EA3, respectively. In plan view, each separator SPR may have a closed curve shape.

The separators SPR of the sub-pixel areas SP1, SP2, and SP3 may be disconnected from each other so as not to be connected to each other. For example, the separator SPR disposed in the first sub-pixel area SP1 may be disconnected from the separator SPR disposed in the second sub-pixel area SP2, and the separator SPR disposed in the second sub-pixel area SP2 may be disconnected from the separator SPR disposed in the third sub-pixel area SP3. In other words, when a structure including the plurality of separators SPR disposed in the plurality of sub-pixel areas SP1, SP2, and SP3 is defined as a separator structure, the separator structure may be disconnected between the adjacent sub-pixel areas SP1, SP2, and SP3. Such a separator SPR may be a structure for cutting the light emitting stack layer IL. To this end, according to an embodiment, the separator SPR may include a first bank BK1 and a second bank BK2 that have different areas.

The first bank BK1 may be disposed on the pixel defining layer PDL. The first bank BK1 may be made of a material including metal. For example, the first bank BK1 may be made of a material including titanium nitride (TiNₓ), tantalum (Ta), and tantalum nitride (TaN).

The second bank BK2 may be disposed on the first bank BK1. The second bank BK2 may be disposed on the first bank BK1 so as to overlap the first bank BK1. In this case, an area of the second bank BK2 may be greater than an area of the first bank BK1. For example, in plan view, the area of the second bank BK2 may be greater than the area of the first bank BK1 so that the first bank BK1 may be surrounded by an edge of the second bank BK2. An etch rate of the second bank BK2 may be different from an etch rate of the first bank BK1. For example, the etch rate of the second bank BK2 may be lower than the etch rate of the first bank BK1. The second bank BK2 may be made of a material including silicon nitride (SiNₓ).

The separator SPR including the first bank BK1 and the second bank BK2 described above may have a smaller width at a lower side thereof than at an upper side thereof in cross section. For example, in a direction parallel to the semiconductor substrate SSUB, an edge of an upper bank (e.g., the second bank BK2) may extend toward an emission area (e.g., EA1) of the pixel defining layer PDL past an edge of a lower bank (e.g., the first bank BK1). Accordingly, in plan view, the edge of the lower bank BK1 may be surrounded by the edge of the upper bank BK2. In other words, the separator SPR may have an undercut shape including a tip TP (e.g., a tip TP of the upper bank BK2). The tip TP of the upper bank BK2 does not overlap the lower bank BK1.

The planarization layer PNS may be a layer capable of planarizing a step between the sub-pixel areas SP1, SP2, and SP3. The planarization layer PNS may be disposed on the separators SPR. For example, the planarization layer PNS may be disposed on each side surface of the separators SPR. In addition, the planarization layer PNS may be disposed between adjacent separators SPR. In this case, the planarization layer PNS may be in contact (or direct contact) with the separators SPR and may be in contact (or direct contact) with the ninth insulating layer INS9. The planarization layer PNS may be made of a material including silicon oxide (SiOₓ).

The light emitting stack layer IL may be disposed on the first electrodes AND, the pixel defining layers PDL, the planarization layer PNS, and the separators SPR. In this case, the light emitting stack layer IL may be cut on the separators SPR. For example, the light emitting stack layer IL may be cut between the first bank BK1 and the second bank BK2. In cross section, the light emitting stack layer IL may be cut along the separator SPR. Accordingly, the light emitting stack layer IL may be divided into a portion in contact with the first electrode AND in the emission area and a portion disposed on an area (e.g., the second bank BK2 of the separator SPR) excluding the emission area. In other words, the light emitting stack layer IL may be cut along the separator SPR so as to be separated for each sub-pixel area. Accordingly, a lateral leakage current between the adjacent sub-pixel areas SP1, SP2, and SP3 may be minimized. As such a lateral leakage current is minimized, a color mixing phenomenon between the adjacent sub-pixel areas SP1, SP2, and SP3 may be prevented, such that image quality of the display device 10 may be improved.

The light emitting stack layer IL may include a plurality of stack layers that are sequentially stacked along the third direction DR3. For example, the light emitting stack layer IL may have a three-tandem structure including a first stack layer, a second stack layer disposed on the first stack layer, and a third stack layer disposed on the second stack layer. Here, the second stack layer may be disposed between the first stack layer and the third stack layer. An embodiment of the present disclosure is not limited thereto. For example, the light emitting stack layer IL may also have a two-tandem structure including two stack layers.

In the three-tandem structure, the first stack layer, the second stack layer, and the third stack layer of the light emitting stack layer IL may provide light of different colors (or wavelengths). For example, any one of the first stack layer, the second stack layer, and the third stack layer may provide light of a first color (e.g., green), another of the first stack layer, the second stack layer, and the third stack layer may provide light of a second color (e.g., red), and the other of the first stack layer, the second stack layer, and the third stack layer may provide light of a third color (e.g., blue).

The first stack layer of the light emitting stack layer IL may have a structure in which a first hole transporting layer, a first organic light emitting layer, and a first electron transporting layer are sequentially stacked. The second stack layer of the light emitting stack layer IL may have a structure in which a second hole transporting layer, a second organic light emitting layer, and a second electron transporting layer are sequentially stacked. The third stack layer of the light emitting stack layer IL may have a structure in which a third hole transporting layer, a third organic light emitting layer, and a third electron transporting layer are sequentially stacked. Here, the first organic light emitting layer, the second organic light emitting layer, and the third organic light emitting layer may provide light of different colors (or wavelengths). For example, any one of the first organic light emitting layer, the second organic light emitting layer, and the third organic light emitting layer may provide light of a first color (e.g., green), another of the first organic light emitting layer, the second organic light emitting layer, and the third organic light emitting layer may provide light of a second color (e.g., red), and the other of the first organic light emitting layer, the second organic light emitting layer, and the third organic light emitting layer may provide light of a third color (e.g., blue).

A first charge generation layer for supplying charges to the second stack layer and supplying electrons to the first stack layer may be disposed between the first stack layer and the second stack layer. The first charge generation layer may include an n-type charge generation layer supplying electrons to the first stack layer and a p-type charge generation layer supplying holes to the second stack layer. The n-type charge generation layer may include a dopant of a metal material.

A second charge generation layer for supplying charges to the third stack layer and supplying electrons to the second stack layer may be disposed between the second stack layer and the third stack layer. The second charge generation layer may include an n-type charge generation layer supplying electrons to the second stack layer and a p-type charge generation layer supplying holes to the third stack layer.

The first stack layer may be disposed on the first electrodes AND and the pixel defining layer PDL. The first stack layer of the light emitting stack layer IL may be disconnected between the sub-pixel areas SP1, SP2, and SP3 neighboring to each other by the separator SPR described above. The second stack layer of the light emitting stack layer IL may be disposed on the first stack layer. The second stack layer of the light emitting stack layer IL may be disconnected between the sub-pixel areas SP1, SP2, and SP3 neighboring to each other by the separator SPR described above. The third stack layer of the light emitting stack layer IL may be disposed on the second stack layer. The third stack layer of the light emitting stack layer IL may not be disconnected by the separator SPR, and may cover the second stack layer.

In the three-tandem structure, the separators SPR may be a structure for disconnecting the first charge generation layer and the second charge generation layer of the display element layer EML between the sub-pixel areas SP1, SP2, and SP3 neighboring to each other. In addition, in the two-tandem structure, the separator SPR may be a structure for disconnecting a charge generation layer disposed between a lower stack layer and an upper stack layer.

The second electrode CAT may be disposed on the light emitting stack layer IL. For example, the second electrode CAT may be disposed on the third stack layer of the light emitting stack layer IL. The second electrode CAT may not be disconnected by the separator SPR, and may be disposed on the third stack layer of the light emitting stack layer IL. The second electrode CAT may be made of a semi-transmissive conductive material such as magnesium (Mg), silver (Ag), or an alloy of magnesium (Mg) and silver (Ag). In this case, light emission efficiency of each of the first to third sub-pixel areas SP1, SP2, and SP3 may be increased by a micro cavity.

The encapsulation layer TFE may be disposed on the display element layer EML. The encapsulation layer TFE may include at least one inorganic film TFE1 or TFE3 in order to prevent oxygen or moisture from permeating into the display element layer EML. For example, the encapsulation layer TFE may include a first encapsulation inorganic film TFE1, an encapsulation organic film TFE2, and a second encapsulation inorganic film TFE3.

The first encapsulation inorganic film TFE1 may be disposed on the second electrode CAT. The first encapsulation inorganic film TFE1 may be formed as multiple films in which one or more inorganic films of a silicon nitride (SiNₓ) film, a silicon oxynitride (SiON) film, and a silicon oxide (SiOₓ) film are alternately stacked. The first encapsulation inorganic film TFE1 may be formed by a chemical vapor deposition (CVD) process.

The encapsulation organic film TFE2 may be made of a monomer. Alternatively, the encapsulation organic film TFE2 may be an organic film made of an acrylic resin, an epoxy resin, a phenolic resin, a polyamide resin, a polyimide resin, or the like.

The second encapsulation inorganic film TFE3 may be disposed on the encapsulation organic film TFE2. The second encapsulation inorganic film TFE3 may be formed as multiple films in which one or more inorganic films of a silicon nitride (SiNₓ) film, a silicon oxynitride (SiON) film, and a silicon oxide (SiOₓ) film are alternately stacked. The second encapsulation inorganic film TFE3 may be formed by a chemical vapor deposition (CVD) process.

An organic film APL may be a layer for increasing interfacial adhesive strength between the encapsulation layer TFE and the optical layer OPL. The organic film APL may be an organic film made of an acrylic resin, an epoxy resin, a phenolic resin, a polyamide resin, a polyimide resin, or the like.

The optical layer OPL includes a plurality of color filters CF1, CF2, and CF3, a plurality of lenses LNS, and a filling layer FIL. The plurality of color filters CF1, CF2, and CF3 may include first to third color filters CF1, CF2, and CF3. The first to third color filters CF1, CF2, and CF3 may be disposed on the organic film APL.

The first color filter CF1 may overlap the first emission area EA1 of the first sub-pixel area SP1. The first color filter CF1 may transmit the first light (e.g., light of a green wavelength band). Therefore, the first color filter CF1 may transmit the first light among light emitted from the light emitting stack layer IL of the first emission area EA1.

The second color filter CF2 may overlap the second emission area EA2 of the second sub-pixel area SP2. The second color filter CF2 may transmit the second light (e.g., light of a red wavelength band). Therefore, the second color filter CF2 may transmit the second light among light emitted from the light emitting stack layer IL of the second emission area EA2.

The third color filter CF3 may overlap the third emission area EA3 of the third sub-pixel area SP3. The third color filter CF3 may transmit the third light (e.g., light of a blue wavelength band). Therefore, the third color filter CF3 may transmit the third light among light emitted from the light emitting stack layer IL of the third emission area EA3.

However, the present disclosure is not limited thereto, and the first color filter CF1 may be a filter transmitting the light of the green wavelength band, the second color filter CF2 may be a filter transmitting the red wavelength band, and the third color filter CF3 may be a filter transmitting the light of the blue wavelength band.

Each of the plurality of lenses LNS may be disposed on each of the first color filter CF1, the second color filter CF2, and the third color filter CF3. Each of the plurality of lenses LNS may be a structure for increasing a ratio of light directed to a front surface of the display device 10. It has been illustrated that each of the plurality of lenses LNS has a cross-sectional shape convex in an upward direction, but an embodiment of the present disclosure is not limited thereto.

The filling layer FIL may be disposed on the plurality of lenses LNS. The filling layer FIL may have a selected refractive index so that light travels in the third direction DR3 at an interface between the plurality of lenses LNS and the filling layer FIL. In addition, the filling layer FIL may be a planarization layer. The filling layer FIL may be an organic film made of an acrylic resin, an epoxy resin, a phenolic resin, a polyamide resin, a polyimide resin, or the like.

The cover layer CVL may be disposed on the filling layer FIL. The cover layer CVL may be a glass substrate or a resin such as a polymer resin. When the cover layer CVL is the glass substrate, the cover layer CVL may be attached onto the filling layer FIL. In this case, the filling layer FIL may serve to adhere the cover layer CVL. When the cover layer CVL is the glass substrate, the cover layer CVL may serve as an encapsulation substrate. When the cover layer CVL is the resin such as a polymer resin, the cover layer CVL may be directly applied onto the filling layer FIL.

The polarizing plate POL may be disposed on one surface of the cover layer CVL. The polarizing plate POL may be a structure for preventing deterioration in visibility due to external light reflection. The polarizing plate POL may include a linear polarizing plate and a phase retardation film. For example, the phase retardation film may be a λ/4 plate (quarter-wave plate), but an embodiment of the present disclosure is not limited thereto. However, when the deterioration in visibility due to the external light reflection is sufficiently improved by the first to third color filters CF1, CF2, and CF3, the polarizing plate POL may be omitted.

According to an embodiment, the separator SPR has an undercut structure, and thus, the lateral leakage current may be minimized. As such a lateral leakage current is minimized, a color mixing phenomenon between the adjacent sub-pixel areas SP1, SP2, and SP3 may be prevented, such that image quality of the display device 10 may be improved.

In addition, according to an embodiment, the first bank BK1 included in the separator and made of a metal material surrounds the sub-pixel area, and it is thus possible to block light from the sub-pixel area from traveling to another sub-pixel area adjacent to the sub-pixel area. Accordingly, the color mixing phenomenon between the adjacent sub-pixel areas SP1, SP2, and SP3 may be prevented, such that the image quality of the display device 10 may be improved.

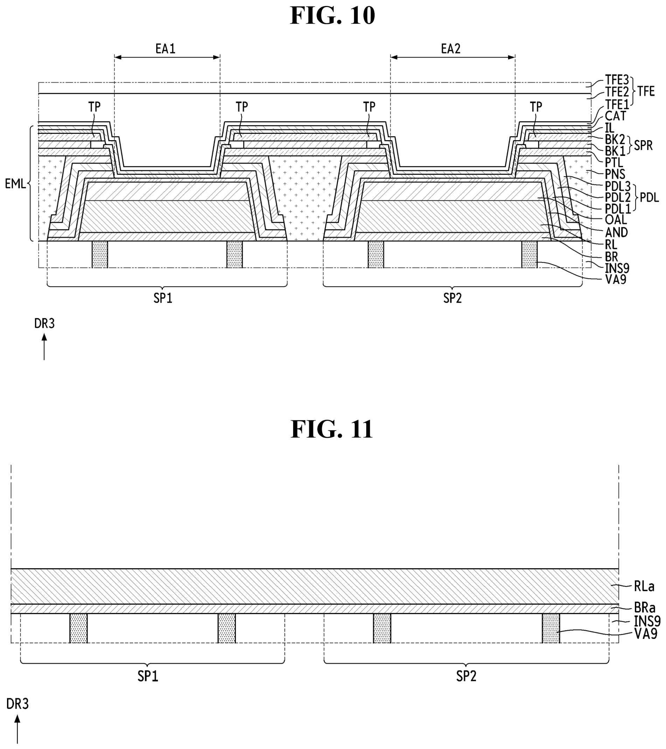

FIG. 10 is a cross-sectional view of a display device 10 according to another embodiment of the disclosure.

The display device 10 of FIG. 10 is different from the display device described above with reference to FIG. 9 in terms of pixel defining layers PDL and a separator SPR and may further include a protective layer PTL, and such differences will be mainly described below.

As illustrated in FIG. 10, the pixel defining layer may include a first pixel defining layer, a second pixel defining layer, and a third pixel defining layer that are disposed at different layers.

The first pixel defining layer PDL1 may be disposed on the first electrode AND. The first pixel defining layer PDL1 may be made of a material including silicon oxide (SiO₂).

The second pixel defining layer PDL2 may be disposed on the first pixel defining layer PDL1. The second pixel defining layer PDL2 may be made of a material including silicon nitride (SiNₓ).

The third pixel defining layer PDL3 may be disposed on the second pixel defining layer PDL2. The third pixel defining layer PDL3 may be made of a material including silicon oxide (SiO₂).

The planarization layer PNS may be disposed on side surfaces of the third pixel defining layer PDL3. In addition, the planarization layer PNS may be disposed between adjacent pixel defining layers PDL.

The protective layer PTL may be disposed on the third pixel defining layers PDL3 and the planarization layer PNS. The protective layer PTL may be made of a material including silicon oxide (SiO₂).

The separator SPR may be disposed on the protective layer PTL. In plan view, the separator SPR may have a mesh shape so as to surround the respective emission areas EA1, EA2, and EA3. According to an embodiment, the separator SPR may include a first bank BK1 and a second bank BK2 that have different areas.

The first bank BK1 may be disposed on the protective layer PTL. The first bank BK1 may be made of a material including metal. For example, the first bank BK1 may be made of a material including titanium nitride (TiNₓ), tantalum (Ta), and tantalum nitride (TaN).

The second bank BK2 may be disposed on the first bank BK1. The second bank BK2 may be disposed on the first bank BK1 so as to overlap the first bank BK1. In this case, an area of the second bank BK2 may be greater than an area of the first bank BK1. For example, in plan view, the area of the second bank BK2 may be greater than the area of the first bank BK1 so that the first bank BK1 may be surrounded by an edge of the second bank BK2. An etch rate of the second bank BK2 may be different from an etch rate of the first bank BK1. For example, the etch rate of the second bank BK2 may be lower than the etch rate of the first bank BK1. The second bank BK2 may be made of a material including silicon oxide (SiO₂).

The separator SPR including the first bank BK1 and the second bank BK2 described above may have a smaller width at a lower side thereof than at an upper side thereof in cross section. For example, in a direction parallel to the semiconductor substrate SSUB, an edge of an upper bank (e.g., the second bank BK2) may extend toward an emission area (e.g., EA1) of the pixel defining layer PDL past an edge of a lower bank (e.g., the first bank BK1). Accordingly, in plan view, the edge of the lower bank BK1 may be surrounded by the edge of the upper bank BK2. In other words, the separator SPR may have an undercut shape including a tip TP (e.g., a tip TP of the upper bank BK2). The tip TP of the upper bank BK2 does not overlap the lower bank BK1.

FIGs. 11 to 23 are views for describing processes of a method for fabricating the display device according to an embodiment of the disclosure. For example, FIGs. 11 to 23 may be cross-sectional views for describing processes of a method for fabricating the display device of FIG. 9.

First, as illustrated in FIG. 11, the ninth insulating layer INS9 may be formed on the semiconductor substrate SSUB, and the ninth via electrode VA9 may be formed in the ninth insulating layer INS9. Thereafter, a preliminary barrier electrode BRa may be formed on the ninth insulating layer INS9 so as to be in contact with the ninth via electrode VA9. Subsequently, a preliminary reflective electrode RLa may be formed on the preliminary barrier electrode BRa.

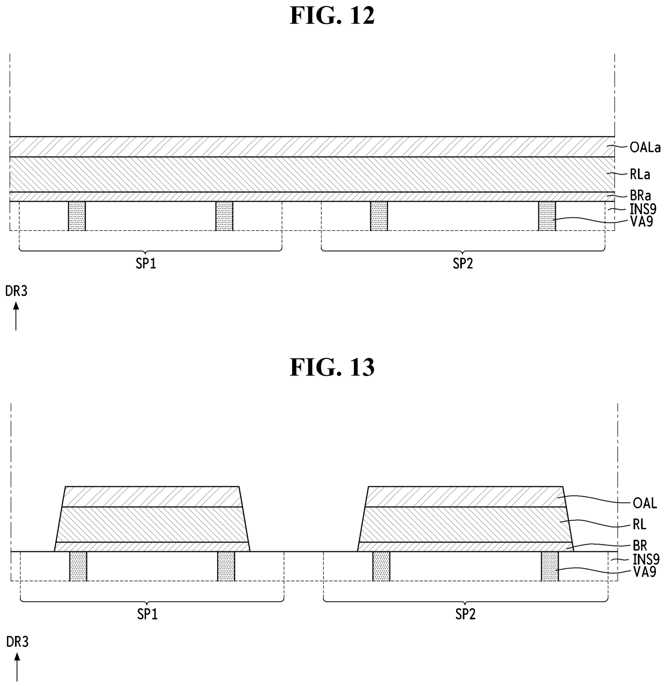

Next, as illustrated in FIG. 12, a preliminary optical auxiliary layer OALa may be formed on the preliminary reflective electrode RLa.

Next, by patterning the preliminary optical auxiliary layer OALa, the preliminary reflective electrode RLa, and the preliminary barrier electrode BRa, the barrier electrode BR, the reflective electrode RL, and the optical auxiliary layer OAL may be formed for each of the sub-pixel areas SP1, SP2, and SP3, as illustrated in FIG. 13. For example, by etching and patterning the preliminary optical auxiliary layer OALa, the preliminary reflective electrode RLa, and the preliminary barrier electrode BRa through an etching process, the barrier electrode BR, the reflective electrode RL, and the optical auxiliary layer OAL may be formed for each of the sub-pixel areas SP1, SP2, and SP3. In this case, the ninth insulating layer INS9 may be exposed.

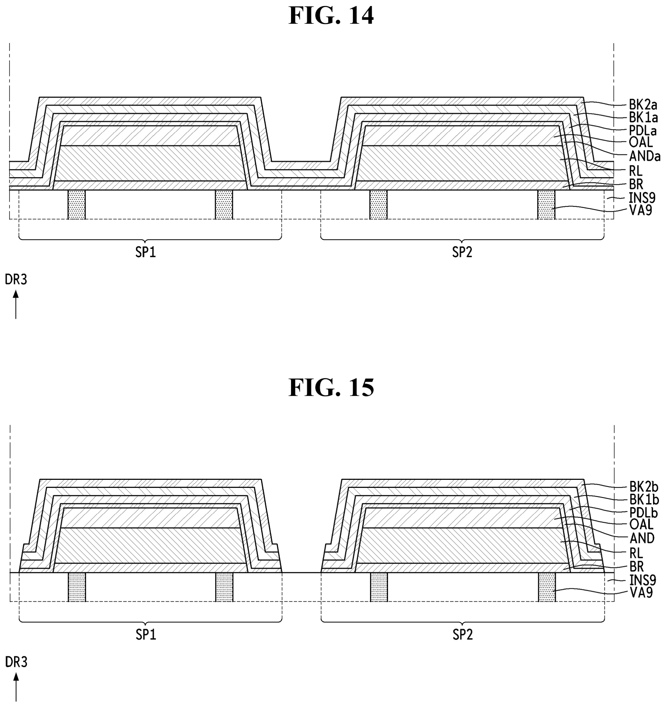

Subsequently, as illustrated in FIG. 14, a first preliminary electrode ANDa may be formed on the ninth insulating layer INS9 and the optical auxiliary layer OAL. In this case, the first preliminary electrode ANDa may be formed on an upper surface of each optical auxiliary layer OAL, side surfaces of each optical auxiliary layer OAL, side surfaces of each reflective electrode RL, and side surfaces of each barrier electrode BR. Here, a thickness of the first preliminary electrode ANDa on the side surfaces of the optical auxiliary layer OAL, the side surfaces of the reflective electrode RL, and the side surfaces of the barrier electrode BR may be smaller than a thickness of the first preliminary electrode ANDa on the upper surface of the optical auxiliary layer OAL. Thereafter, a first preliminary pixel defining layer PDLa may be formed on the first preliminary electrode ANDa, a first preliminary bank BK1a may be formed on the first preliminary pixel defining layer PDLa, and a second preliminary bank BK2a may be then formed on the first preliminary bank BK1a.

Next, by patterning the second preliminary bank BK2a, the first preliminary bank BK1a, and the first preliminary pixel defining layer PDLa, a second preliminary pixel defining layer PDLb, a third preliminary bank BK1b, and a fourth preliminary bank BK2b may be formed for each of the sub-pixel areas SP1, SP2, and SP3, as illustrated in FIG. 15. For example, by etching and patterning the second preliminary bank BK2a, the first preliminary bank BK1a, and the first preliminary pixel defining layer PDLa through an etching process, the second preliminary pixel defining layer PDLb, the third preliminary bank BK1b, and the fourth preliminary bank BK2b may be formed for each of the sub-pixel areas SP1, SP2, and SP3. In this case, the ninth insulating layer INS9 may be exposed.

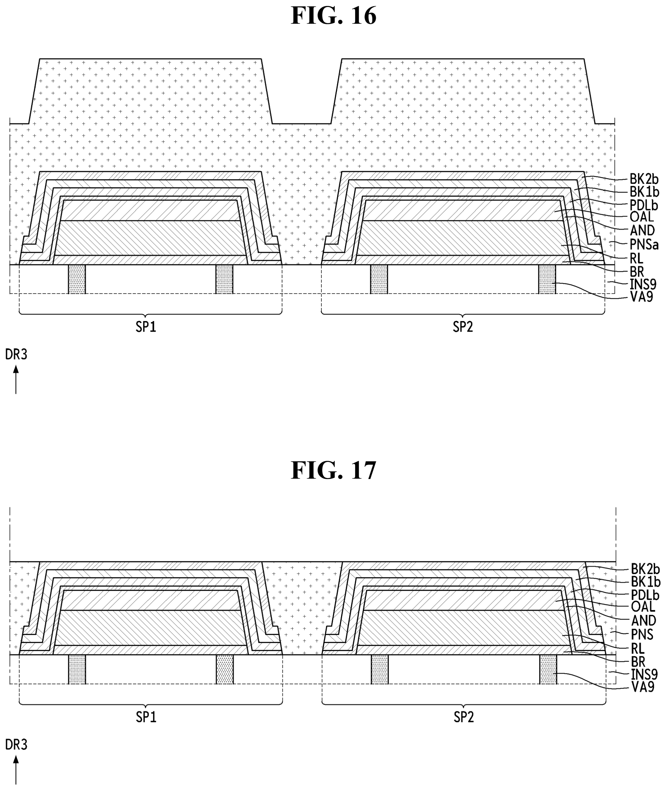

Next, as illustrated in FIG. 16, a preliminary planarization layer PNSa may be formed on the ninth insulating layer INS9 and the fourth preliminary bank BK2b. The preliminary planarization layer PNSa may have a bend along a step of an underlying structure. In this case, the lowest portion of the preliminary planarization layer PNSa may be higher than the highest portion of the fourth preliminary bank BK2b.

Thereafter, as illustrated in FIG. 17, the planarization layer PNS may be formed by removing a portion of the preliminary planarization layer PNSa above the fourth preliminary bank BK2b. For example, the planarization layer PNS may be formed by removing the preliminary planarization layer PNSa through chemical mechanical polishing (CMP). In other words, the preliminary planarization layer PNSa may be removed until the fourth preliminary bank BK2b is exposed. An upper surface of the planarization layer PNS may be disposed at substantially the same height as the highest portion of the fourth preliminary bank BK2b. Here, the fourth preliminary bank BK2b layer may function as an etch stop layer during a chemical mechanical polishing process.

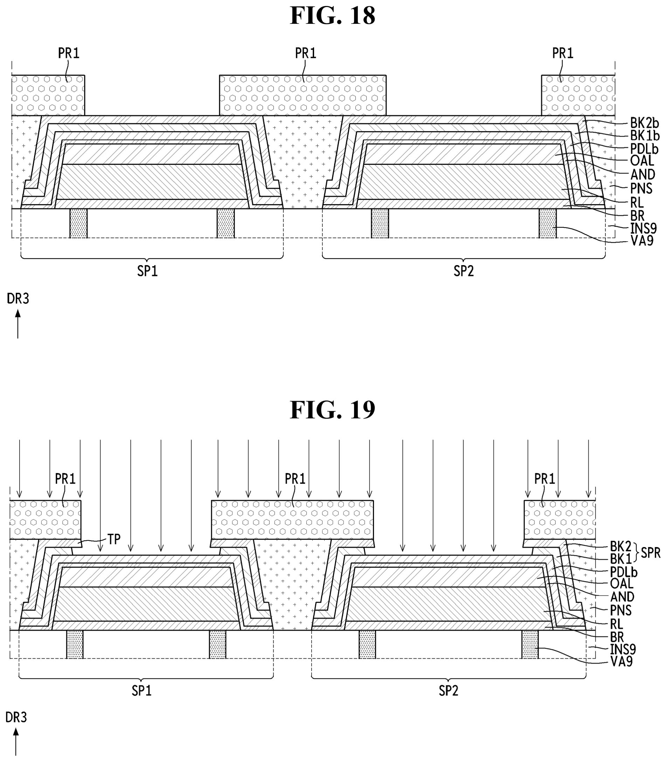

Next, as illustrated in FIG. 18, a first photoresist pattern PR1 may be formed on the planarization layer PNS and the fourth preliminary bank BK2b. For example, the first photoresist pattern PR1 may be formed on the planarization layer PNS and the fourth preliminary bank BK2b so as not to overlap each of the emission areas EA1, EA2, and EA3.

Next, as illustrated in FIG. 19, the fourth preliminary bank BK2b and the third preliminary bank BK1b may be patterned using the first photoresist pattern PR1 as a mask. For example, by etching and patterning the fourth preliminary bank BK2b and the third preliminary bank BK1b through an etching process that uses the first photoresist pattern PR1 as the mask, the first bank BK1 and the second bank BK2 may be formed. In this case, the third preliminary bank BK1b disposed below the fourth preliminary bank BK2b has a higher etch rate than the fourth preliminary bank BK2b, and thus, the third preliminary bank BK1b may be etched faster than the fourth preliminary bank BK2b during the etching process. Accordingly, after the etching (e.g., over etching) is completed, an area of the first bank BK1 may be smaller than an area of the second bank BK2, as illustrated in FIG. 19. Accordingly, a structure including the first bank BK1 and the second bank BK2 may have an undercut shape including the tip TP. By patterning the fourth preliminary bank BK2b and the third preliminary bank BKlb using the first photoresist pattern PR1 as the mask as described above, the second pixel defining layer PDLb may be exposed.

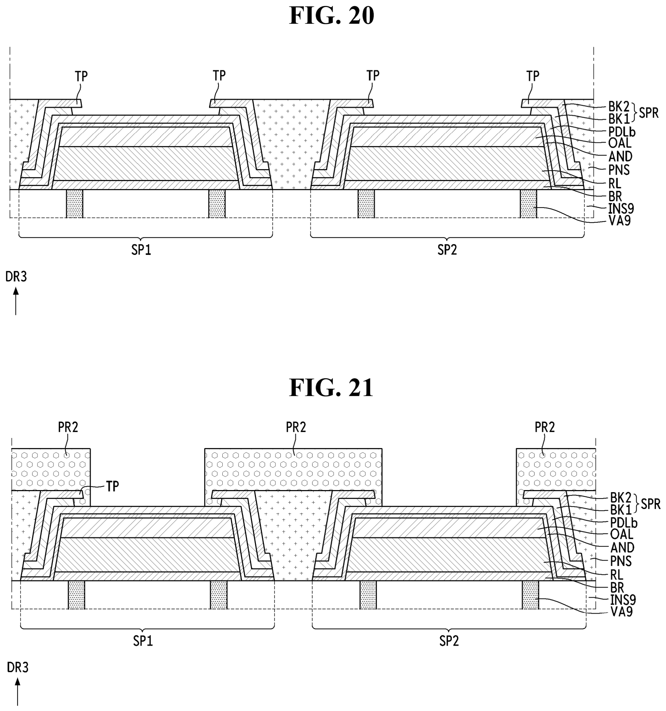

Thereafter, as illustrated in FIG. 20, the first photoresist pattern PR1 may be removed after the etching process is completed.

Next, as illustrated in FIG. 21, a second photoresist pattern PR2 may be formed on the second preliminary pixel defining layer PDLb, the second bank BK2, and the planarization layer PNS. For example, the second photoresist pattern PR2 may be formed on the second preliminary pixel defining layer PDLb, the second bank BK2, and the planarization layer PNS so as not to overlap each of the emission areas EA1, EA2, and EA3.

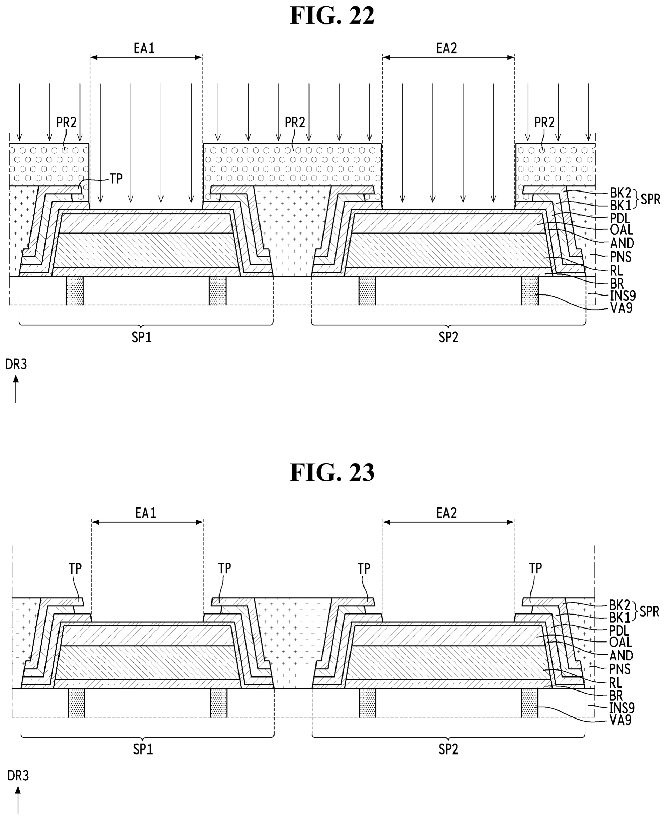

Subsequently, as illustrated in FIG. 22, the second preliminary pixel defining layer PDLb may be patterned using the second photoresist pattern PR2 as a mask. For example, by etching and patterning the second preliminary pixel defining layer PDLb through an etching process that uses the second photoresist pattern PR2 as the mask, the pixel defining layer PDL may be formed. For example, the pixel defining layers PDL defining the first emission area EA1, the second emission area EA2, and the third emission area EA3 may be formed. Accordingly, the first electrode AND may be exposed for each of the sub-pixel areas SP1, SP2, and SP3 through each of the emission areas EA1, EA2, and EA3.

Thereafter, as illustrated in FIG. 23, the second photoresist pattern PR2 may be removed.

Next, as illustrated in FIG. 9, the light emitting stack layer IL may be formed on the first electrodes AND, the pixel defining layers PDL, and the separators SPR, the second electrode CAT may be formed on the light emitting stack layer IL, and the encapsulation layer TFE may be formed on the second electrode CAT. Here, the light emitting stack layer IL may be separated for each of the sub-pixel areas SP1, SP2, and SP3 by the separators SPR.

The display device 10 according to an embodiment may be applied to various electronic devices. An electronic device according to an embodiment includes the display device 10 described above, and may further include modules or devices having other additional functions in addition to the display device 10.

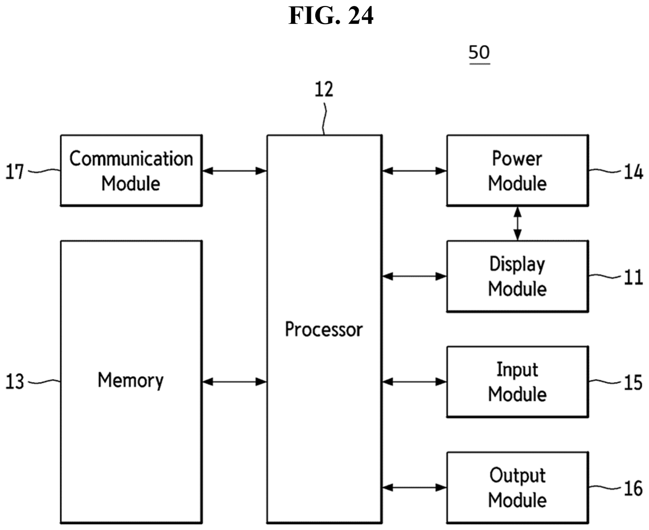

FIG. 24 is a block diagram of an electronic device according to an embodiment of the disclosure. Referring to FIG. 24, an electronic device 50 according to an embodiment may include a display module 11, a processor 12, a memory 13, and a power module 14. The electronic device 50 may further include an input module 15, an output module (e.g., a non-image output module) 16, and/or a communication module 17.

The electronic device 50 may output various information in the form of an image through the display module 11. When the processor 12 executes an application stored in the memory 13, image information provided by the application may be provided to a user through the display module 11. The power module 14 may include a power supply module such as a power adapter or a battery device and a power conversion module converting power supplied by the power supply module to generate power required for an operation of the electronic device 50. The input module 15 may provide input information to the processor 12 and/or the display module 11. The output module 16 may serve to receive information other than an image received from the processor 12, such as sound information, haptic information, and light emitting information, and provide the received information to the user. The communication module 17 is a module in charge of transmitting and receiving information between the electronic device 50 and an external device, and may include a receiving unit and a transmitting unit.

At least one of the respective components of the above-described electronic device 50 may be included in the display device according to the above-described embodiments. In addition, some of individual modules functionally included in one module may be included in the display device, and the others of the individual modules may be provided separately from the display device. For example, the display device may include the display module 11, and the processor 12, the memory 13, and the power module 14 may be provided in the form of other devices within the electronic device 50 rather than the display device.

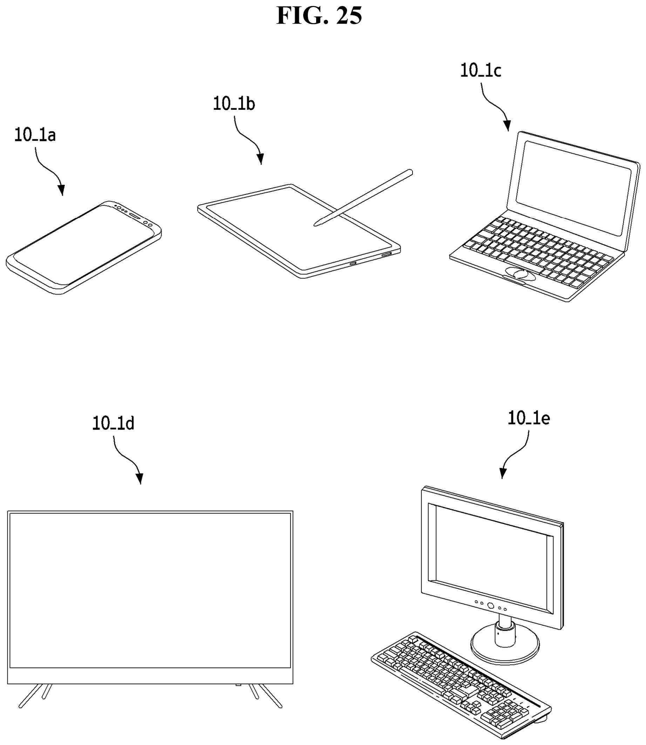

FIGs. 25 to 27 are schematic views of electronic devices according to various embodiments. FIGs. 25 to 27 illustrate examples of various electronic devices to which the display device 10 according to embodiments is applied.

FIG. 25 illustrates a smartphone 10_1a, a tablet personal computer (PC) 10_1b, a laptop computer 10_1c, a television (TV) 10_1d, and a monitor 10_1e for a desktop computer as examples of the electronic devices.

The smartphone 10_1a may include an input module such as a touch sensor and a communication module in addition to the display module 11. The smartphone 10_1a may process information received through the communication module or other input modules and display the processed information through the display module of the display device.

Each of the tablet PC 10_1b, the laptop computer 10_1c, the TV 10_1d, and the monitor 10_1e for a desktop computer may include a display module and an input module, similar to the smartphone 10_1a, and may further include a communication module in some cases.

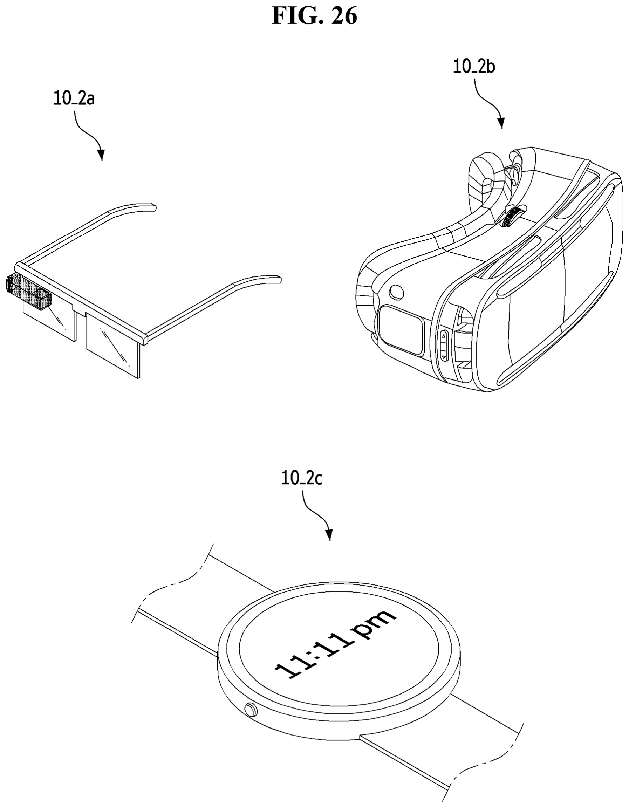

FIG. 26 illustrates a case where an electronic device including a display module is applied to a wearable electronic device. The wearable electronic device may be smart glasses 10_2a, a head mounted display 10_2b, a smart watch 10_2c, or the like.

Each of the smart glasses 10_2a and the head mounted display 10_2b may include a display module emitting a display image and a reflector reflecting the emitted display image and providing the emitted display image to user's eyes, and accordingly, may provide a virtual reality screen or an augmented reality screen to the user.

The smart watch 10_2c may include a biometric sensor as an input device, and may provide biometric information recognized through the biometric sensor to the user through the display module.

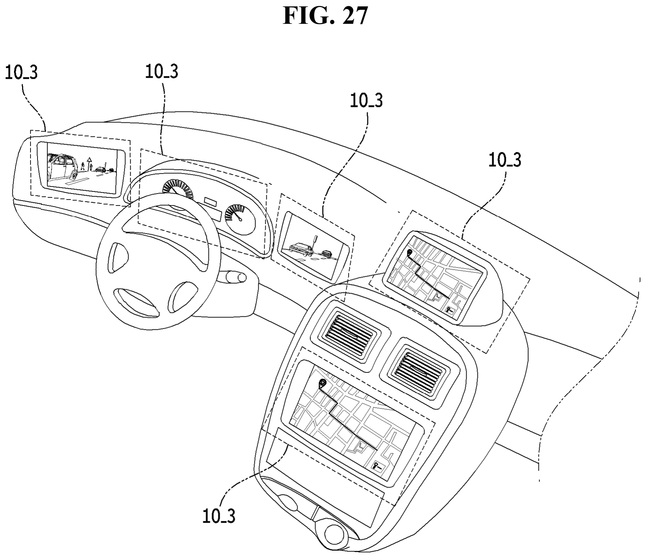

FIG. 27 illustrates a case where an electronic device including a display module is applied to a vehicle. For example, an electronic device 10_3 may be applied to an instrument board, a center fascia, or the like, of the vehicle or applied to a center information display (CID) disposed on a dashboard of the vehicle, a room mirror display substituting for a side-view mirror, or the like.

## Claims

1. A display device (10) comprising:
a substrate (SSUB) including a sub-pixel area (SP1, SP2, SP3);
a reflective electrode (RL) disposed in the sub-pixel area (SP1, SP2, SP3) on the substrate (SSUB);
a first electrode (AND) disposed on the substrate (SSUB) so as to surround the reflective electrode (RL);
a pixel defining layer (PDL) which is disposed on the first electrode (AND) and in which an emission area (EA1, EA2, EA3) overlapping the first electrode (AND) is defined; and
a separator (SPR) disposed on the pixel defining layer (PDL),
wherein the separator (SPR) includes:
a first bank (BK1) disposed on the pixel defining layer (PDL) so as not to overlap the emission area (EA1, EA2, EA3); and
a second bank (BK2) disposed on the first bank (BK1) so as not to overlap the emission area (EA1, EA2, EA3),
wherein the second bank (BK2) includes a tip (TP) that overlaps the pixel defining layer (PDL) and does not overlap the first bank (BK1).

2. The display device (10) of claim 1, wherein an etch rate of the first bank (BK1) is higher than an etch rate of the second bank (BK2).

3. The display device (10) of claim 1 or claim 2, wherein the first bank (BK1) is made of a material including metal.

4. The display device (10) of any one of claims 1 to 3, wherein the first bank (BK1) is made of a material including any one of titanium nitride, tantalum, and tantalum nitride.

5. The display device (10) of any one of claims 1 to 4, wherein the second bank (BK2) is made of a material including silicon nitride.

6. The display device (10) of any one of claims 1 to 5, wherein the number of sub-pixel areas (SP1, SP2, SP3) is plural,
the pixel defining layer (PDL) defines a first emission area (EA1) of a first sub-pixel and a second emission area (EA2) of a second sub-pixel, and
the emission area (EA1) of the first sub-pixel and the emission area (EA2) of the second sub-pixel have different sizes.

7. The display device (10) of any one of claims 1 to 6, further comprising an optical auxiliary layer (OAL) disposed between the reflective electrode (RL) and the first electrode (AND).

8. The display device (10) of claim 7, further comprising a barrier electrode (BR) disposed between the substrate (SSUB) and the reflective electrode (RL).

9. The display device (10) of claim 8, wherein the first electrode (AND) is disposed on side surfaces of the barrier electrode (BR), side surfaces of the reflective electrode (RL), and side surfaces of the optical auxiliary layer (OAL), and an upper surface of the optical auxiliary layer (OAL).

10. The display device (10) of any one of claims 1 to 9, further comprising a planarization layer (PNS) disposed on side surfaces of the second bank (BK2).

11. The display device (10) of claim 10, further comprising a light emitting stack (IL) layer disposed on the first electrode (AND), the pixel defining layer (PDL), the second bank (BK2), and the planarization layer (PNS), and a second electrode (CAT) disposed on the light emitting stack layer (IL), optionally wherein at least some of a plurality of light emitting layers included in the light emitting stack layer (IL) disposed on the second bank (BK2) are disconnected from the light emitting stack layer (IL) disposed on the first electrode (AND).

12. The display device (10) of any one of claims 1 to 11, wherein the pixel defining layer (PDL) includes:
a first pixel defining layer (PDL1) disposed on the first electrode (AND);
a second pixel defining layer (PDL2) disposed on the first pixel defining layer (PDL1); and
a third pixel defining layer (PDL3) disposed on the second pixel defining layer (PDL2).

13. An electronic device (50) comprising a display device (10) providing a display screen,
wherein the display device (10) is the display device of any one of claims 1 to 12.

14. The electronic device (50) of claim 13, wherein:
(i) the display device (10) includes an active area that displays an image and an inactive area that is disposed outside the active area and does not display an image, and
a maximum width of the active area is 1.5 inches or less; and/or
(ii) the electronic device (50) comprises a wearable device including a head mounted display (10_2b), smart glasses (10_2a), or a smart watch (10_2c).

15. A method for fabricating a display device (10), comprising:
preparing a substrate (SSUB) in which an insulating layer (INS9) and a via electrode (VA9) penetrating through the insulating layer (INS9) are formed;
forming a barrier electrode (BR), a reflective electrode (RL), and an optical auxiliary layer (OAL) that are sequentially stacked on the via electrode (VA9);
sequentially forming a first preliminary electrode (ANDa), a first preliminary pixel defining layer (PDLa), a first preliminary bank (BK1a), and a second preliminary bank (BK2a) on the optical auxiliary layer (OAL) and the insulating layer (IL);
forming a first electrode (AND), a second preliminary pixel defining layer (PDLb), a third preliminary bank (BK1b), and a fourth preliminary bank (BK2b) by patterning the first preliminary electrode (ANDa), the first preliminary pixel defining layer (PDLa), the first preliminary bank (BK1a), and the second preliminary bank (BK2a);
forming a preliminary planarization layer (PNSa) on the first electrode (AND), the second preliminary pixel defining layer (PDLb), the third preliminary bank (BK1b), the fourth preliminary bank (BK2b), and the insulating layer (INS9);
forming a planarization layer (PNS) on side surfaces of the fourth preliminary bank (BK2b) by removing the preliminary planarization layer (PNSa) until the fourth preliminary bank (BK2b) is exposed;
forming a first photoresist pattern (PR1) on the fourth preliminary bank (BK2b) and the planarization layer (PNS) so as not to overlap an emission area (EA1, EA2, EA3) of a sub-pixel; and
forming a first bank (BK1) and a second bank (BK2) by patterning the fourth preliminary bank (BK2b) and the third preliminary bank (BK1b) using the first photoresist pattern (PR1) as a mask, the second bank (BK2) being disposed on the first bank (BK1),
wherein the second bank (BK2) includes a tip (TP) that overlaps the second preliminary pixel defining layer (PDLb) and does not overlap the first bank (BK1).
